(19) Europäisches Patentamt / European Patent Office / Office européen des brevets

(11) **EP 3 528 256 B1**

(12) **FASCICULE DE BREVET EUROPEEN**

(45) Date de publication et mention
de la délivrance du brevet:
**12.02.2025 Bulletin 2025/07**

(51) Classification Internationale des Brevets (IPC):
**H10N 50/85** (2023.01)  **H01F 10/12** (2006.01)
**H10N 50/10** (2023.01)  **H01F 10/32** (2006.01)
**G11C 11/16** (2006.01)

(21) Numéro de dépôt: **19157406.0**

(22) Date de dépôt: **15.02.2019**

(52) Classification Coopérative des Brevets (CPC):
**G11C 11/1659; G11C 11/161; G11C 11/1675;
H01F 10/3286; H10N 50/10; H10N 50/85;**
H01F 10/3272

(54) **EMPILEMENT MAGNETIQUE, MULTICOUCHE, JONCTION TUNNEL, POINT MEMOIRE ET CAPTEUR COMPORTANT UN TEL EMPILEMENT**

MAGNETISCHER MEHRSCHICHTENSTAPEL MIT TUNNELÜBERGANG, SPEICHERPUNKT UND SENSOR, DER EINEN SOLCHEN STAPEL UMFASST

MULTILAYER MAGNETIC STACK, TUNNEL JUNCTION, MEMORY POINT AND SENSOR COMPRISING SUCH A STACK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.02.2018 FR 1851302**

(43) Date de publication de la demande:
**21.08.2019 Bulletin 2019/34**

(73) Titulaires:
• **Commissariat à l'Energie Atomique et aux Energies Alternatives**
**75015 Paris (FR)**
• **Université Grenoble Alpes**
**38400 Saint Martin d'Hères (FR)**
• **Centre National de la Recherche Scientifique - CNRS**
**75016 Paris (FR)**

(72) Inventeurs:
• **CHATTERJEE, Jyotirmoy**
**38054 Grenoble (FR)**
• **VELOSO COELHO, Paulo**
**38054 Grenoble (FR)**
• **DIENY, Bernard**
**38054 Grenoble (FR)**
• **SOUSA, Ricardo**
**38054 Grenoble (FR)**
• **PREJBEANU, Lucian**
**38054 Grenoble (FR)**

(74) Mandataire: **Cabinet Camus Lebkiri**
**25 rue de Maubeuge**
**75009 Paris (FR)**

(56) Documents cités:
**WO-A1-2017/052606      US-B2- 8 546 897**

• SWERTS J ET AL: "Top pinned magnetic tunnel junction stacks with high annealing tolerance for high density STT-MRAM applications", 2017 IEEE INTERNATIONAL MAGNETICS CONFERENCE (INTERMAG), IEEE, 24 April 2017 (2017-04-24), pages 1 - 1, XP033140940, DOI: 10.1109/INTMAG.2017.8007702
• CHATTERJEE JYOTIRMOY ET AL: "Enhanced annealing stability and perpendicular magnetic anisotropy in perpendicular magnetic tunnel junctions using W layer", APPLIED PHYSICS LETTERS, A I P PUBLISHING LLC, US, vol. 110, no. 20, 15 May 2017 (2017-05-15), pages 1 - 5, XP012218869, ISSN: 0003-6951, [retrieved on 20170515], DOI: 10.1063/1.4983159

- **SWERTS J ET AL: "Solving the BEOL compatibility challenge of top-pinned magnetic tunnel junction stacks", 2017 IEEE INTERNATIONAL ELECTRON DEVICES MEETING (IEDM), IEEE, 2 December 2017 (2017-12-02), XP033306100, DOI: 10.1109/ IEDM.2017.8268518**

**Description**

**DOMAINE TECHNIQUE DE L'INVENTION**

La présente invention concerne une multicouche magnétique à aimantation hors du plan. On appelle « multicouche magnétique à aimantation hors du plan» une multicouche magnétique qui présente une aimantation sensiblement perpendiculaire au plan suivant lequel s'étend l'empilement ou plan des couches. Un objet de la présente invention est de proposer une multicouche ne nécessitant pas d'être déposé sur une couche de croissance ayant une symétrie cristalline prédéterminée pour obtenir une forte anisotropie magnétique en dehors du plan des couches. Cette multicouche est avantageusement apte à supporter des températures pouvant être élevées telles qu'en particulier celles des recuits post-dépôt (généralement à une température supérieure à 300°C) sans dégradation des propriétés magnétiques qui pourraient avoir lieu à la suite de phénomènes d'inter-diffusion dans la multicouche, à températures élevées.

Un objet préféré de l'invention est une jonction tunnel magnétique comportant la multicouche selon l'invention. Un autre objet préféré concerne également d'autres dispositifs spintroniques à aimantation perpendiculaire comprenant la multicouche selon l'invention :

- un point mémoire à deux ou trois terminaux pour une cellule mémoire
- une double jonction tunnel magnétique ;
- une jonction tunnel magnétique pour une cellule mémoire à plusieurs niveaux ;
- un point mémoire à trois terminaux pour une cellule mémoire à plusieurs niveaux;
- un capteur pour la mesure d'un champ magnétique appliqué.

**ETAT DE L'ART**

Les jonctions tunnel magnétiques (ou « Magnetic Tunnel Junctions » selon la terminologie anglaise, MTJ) constituent une brique fondamentale des dispositifs spintroniques.

Une jonction tunnel magnétique est formée par deux électrodes magnétiques séparées par une couche mince agissant en tant que barrière tunnel. La couche tunnel est souvent en MgO avec une épaisseur comprise entre 1 nm et 2 nm. Une des électrodes magnétiques, appelée couche de référence, possède une aimantation fixée grâce à une couche antiferromagnétique synthétique (ou « Synthetic antiferromagnetic layer » selon la terminologie anglaise, SAF). La deuxième électrode magnétique, appelée couche de stockage, possède une aimantation qui peut s'orienter soit parallèlement soit antiparallèlement à la direction d'aimantation de la couche de référence.

L'état d'aimantation de la MTJ peut être lu en mesurant sa résistance électrique qui varie selon la configuration magnétique des deux électrodes magnétiques du fait du phénomène de magnétorésistance tunnel.

Ainsi, la configuration ayant les aimantations des deux couches (de stockage et de référence) orientées parallèlement correspond à un état de faible résistance de la MTJ (Rmin). La configuration ayant les aimantations des deux couches orientées antiparallèlement correspond à un état de forte résistance de la MTJ (Rmax). L'écart relatif de résistance entre les deux configurations (Rmax-Rmin)/Rmin représente l'amplitude de magnétorésistance tunnel qui peut dépasser 200% à température ambiante. Ces deux états magnétiques peuvent être utilisée pour encoder un « bit » d'information.

L'inversion de l'aimantation de la couche de stockage est réalisée par un courant qui traverse l'empilement selon la direction perpendiculaire au plan des couches. Ce courant est également appelé courant d'écriture.

Par exemple, les jonctions tunnel magnétiques sont utilisées en tant qu'éléments de stockage dans les mémoires magnétiques de type « Spin Transfer Torque » ou STT-MRAM.ou encore dans les mémoires magnétiques de type « Thermally Assisted Switching » ou TAS-MRAM.

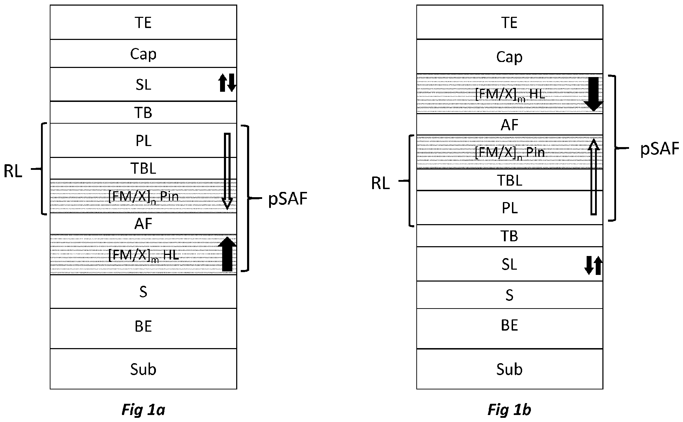

Une jonction tunnel magnétique selon l'état de l'art est illustrée à la figure 1a. Une telle jonction tunnel magnétique comprend :

- une couche de substrat Sub ;
- une électrode inférieure BE ;
- une couche de croissance S ou « seed layer » selon la terminologie anglaise ;
- une couche dure HL antiferromagnétiquement couplée à une couche de référence RL par une couche de couplage AF pour former une couche antiferromagnétique synthétique pSAF ;
- Une couche de référence RL formée par une couche de piégeage Pin ou « pinning layer » selon la terminologie anglaise, une couche de transition structurale de symétrie TBL ou « texture breaking layer » selon la terminologie anglaise et une couche de polarisation de spin PL ;
- Une couche barrière tunnel TB ;
- Une couche de stockage SL ;

- Une couche de protection Cap ;
- Une électrode supérieure TE.

La fonction de ces différentes couches est expliquée dans ce qui suit.

Les deux couches électrodes inférieure BE et supérieure TE permettent la réalisation de contacts électriques pour faire circuler un courant normal au plan de couches, ce courant pouvant être utilisé pour écrire ou lire l'état de la jonction tunnel magnétique. La couche de croissance S ou « seed layer » est utilisée pour favoriser une symétrie cristalline prédéterminée dans la couche dure HL et dans la couche de piégeage Pin. La symétrie cristalline de la couche de croissance S permet d'obtenir une couche de piégeage Pin et une couche dure HL ayant une anisotropie magnétique perpendiculaire élevée pour obtenir une aimantation de la couche de référence stable dans le temps.

La couche barrière tunnel TB sépare la couche de stockage SL, ayant une aimantation variable, et la couche de référence RL, ayant une aimantation fixe, et permet d'obtenir une magnétorésistance tunnel entre les deux électrodes.

La couche dure HL est antiferromagnétiquement couplée à la couche de référence RL par la couche AF, le couplage antiferromagnétique permettant d'augmenter la coercivité magnétique et donc la stabilité magnétique de l'empilement pSAF et de réduire le champ parasite exercé par la couche de référence sur la couche de stockage.

Dans la plupart des jonctions tunnel magnétiques MTJs, l'aimantation est hors du plan, à savoir perpendiculaire au plan des couches. Ces empilements sont également appelés jonctions tunnel magnétiques perpendiculaires ou pMTJs. Une telle orientation permet de trouver un bon compromis entre la stabilité thermique de l'aimantation de la couche de stockage qui définit la rétention de la mémoire et l'intensité de courant d'écriture. Dans les pMTJs la couche de référence RL doit posséder une forte anisotropie magnétique perpendiculaire, de sorte à garder une aimantation stable pendant toute la durée de vie du dispositif. A cette fin, la couche de référence RL comprend une couche de polarisation PL couplée à une couche de piégeage Pin ayant une forte anisotropie magnétique perpendiculaire, le couplage étant réalisé par une couche comprenant du bore. La couche de piégeage Pin peut être une multicouche formée par une répétition de bicouches de type FM/X. On entend ici par FM une couche ferromagnétique comprenant par exemple un des matériaux suivants Co, Fe, CoFe ou un alliage de ces matériaux. On entend par X une couche métallique magnétique ou non-magnétique comprenant par exemple un des matériaux suivants : Pt, Au, Ir, Pd, Ni, NiCo, NiFe, NiFeCo ou un alliage de ces matériaux. On entend par la notation $[FM/X]_n$ une superposition de n bicouches FM/X. Les couches de polarisation PL et de piégeage Pin peuvent produire un champ parasite qui perturbe l'aimantation de la couche de stockage SL. Pour réduire cet effet une couche à aimantation fixe ou couche dure HL est utilisée. La couche dure HL est caractérisée par une valeur élevée de champ coercitif. La couche dure HL est antiferromagnétiquement couplée à la couche de piégeage Pin. Le couplage antiferromagnétique est réalisé grâce à la couche de couplage AF comprenant l'un des matériaux Ru, Re, Rh, Ir, Os ou un alliage de ces matériaux. Comme il est bien connu de l'homme du métier, il est nécessaire de contrôler précisément l'épaisseur de cette couche de couplage AF pour obtenir un couplage antiferromagnétique. Par exemple, pour une couche de couplage antiferromagnétique en Ru, une épaisseur comprise entre 0.3 et 0.9 nm doit être utilisée. La couche dure HL est elle aussi constituée par une répétition de bicouches de type FM/X, avec une anisotropie magnétique perpendiculaire élevée. L'ensemble de couches formé par la couche dure, la couche de couplage antiferromagnétique, la couche de piégeage, la couche de transition structurale de symétrie et la couche de polarisation est aussi appelé couche antiferromagnétique synthétique avec anisotropie perpendiculaire pSAF.

Il existe deux types de jonctions magnétiques tunnel à aimantation perpendiculaire pMTJs illustrés à la figure 1. La figure 1a montre un exemple de pMTJs dans laquelle l'élément antiferromagnétique synthétique à aimantation perpendiculaire pSAF se trouve au-dessous de la barrière tunnel. Dans ce type de jonction tunnel magnétique la couche de stockage SL se trouve au-dessus de la barrière tunnel d'où la dénomination de « top storage pMTJ » selon la terminologie anglaise ou TS-pMTJ. La figure 1b montre un exemple de pMTJs dans laquelle l'élément antiferromagnétique synthétique à aimantation perpendiculaire pSAF se trouve au-dessus de la barrière tunnel. Dans ce type de jonction la couche de stockage se trouve au-dessous de la barrière tunnel TB, d'où la dénomination de « bottom storage pMTJ » selon la terminologie anglaise ou BS-pMTJ.

Une jonction tunnel magnétique de type BS-pMTJ permet d'avoir une surface plus régulière pour la croissance de la couche de stockage et de la barrière tunnel. De plus, une jonction tunnel magnétique de type BS-pMTJ peut être utilisée dans la fabrication de mémoires magnétiques à accès aléatoire de type couple spin-orbite ou SOT-MRAM selon la terminologie anglaise « Spin Orbit Torque Magnetic Random Access Memory ». En effet, dans une mémoire de type SOT-MRAM, la couche de stockage doit être en contact avec une bande métallique placée au-dessous de la jonction tunnel magnétique. Dans une jonction tunnel de type SOT-MRAM la couche de stockage doit donc se trouver à la base de la jonction.

Comme illustré à la figure 1b, la fabrication d'une jonction tunnel magnétique de type SOT-MRAM requiert la croissance d'un élément antiferromagnétique synthétique pSAF ayant une anisotropie magnétique perpendiculaire élevée directement au-dessus de la barrière tunnel. En d'autres termes, la croissance de l'élément pSAF ne peut pas être réalisée au-dessus d'une couche de croissance ayant une symétrie opportunément choisie pour favoriser une anisotropie magnétique perpendiculaire élevée.

Dans une jonction tunnel de type BS-pMTJ, il est donc impossible d'obtenir la structure cristalline souhaitée en utilisant une couche de croissance ayant une symétrie donnée. Au contraire l'élément antiferromagnétique synthétique perpendiculaire pSAF doit être réalisé directement au contact de la barrière tunnel pour pouvoir produire l'effet de magnétorésistance tunnel permettant la lecture de l'état magnétique de la jonction. Ces difficultés limitent fortement la réalisation des mémoires de type SOT-MRAM ayant une anisotropie magnétique perpendiculaire élevée et leur utilisation dans des dispositifs spintroniques.

D'après la demande de brevet FR 2976396, il est possible d'augmenter l'anisotropie magnétique perpendiculaire d'un empilement de type FM/X grâce à l'ajout d'une couche I intermédiaire entre la couche ferromagnétique FM et la couche non ferromagnétique X, I étant un matériau peu miscible avec la couche FM.

Toutefois, ces empilements magnétiques connus ont une stabilité thermique qui n'est pas satisfaisante. En effet, ils peuvent perdre leur anisotropie perpendiculaire à des températures de recuits de l'ordre de 300°C qui sont trop faibles par rapport à celles requises pour une intégration dans une technologie CMOS (Complementary Metal Oxide Semiconductor) qui nécessite des recuits à 400°C.

Par ailleurs, les matériaux I divulgués dans le document FR2976396 ne permettent pas d'avoir des interfaces entre les différentes couches de l'empilement FM/I/X suffisamment lisses et régulières. Par ailleurs, ces matériaux ne permettent pas d'éviter les défauts interfaciaux, notamment ceux créés lors de la croissance des couches X, souvent composées par des métaux lourds tels que Pt ou Pd.

Les documents "Top pinned magnetic tunnel junction stacks with high annealing tolerance for high density STT-MRAM applicants", J. Swerts et al., 2017 IEEE International Magnetics Conference , 24 avril 2017, page 1; "Enhanced annealing stability and perpendicular magnetic anisotropy in perpendicular magnetic tunnel junctions using W layer", Jyotirmoy Chatterjee et al, Applied Physics Letters, vol.110, no.20, 15 mai 2017, pages 1-5; et WO2017/052606 A1 divulguent des jonctions tunnel magnétiques de l'art antérieur.

## PROBLEME TECHNIQUE

Les empilements magnétiques ayant une forte anisotropie magnétique perpendiculaire sont aujourd'hui majoritairement obtenus par dépôt au-dessus d'une couche de croissance ayant une structure cristalline opportunément choisie pour favoriser l'anisotropie magnétique perpendiculaire.

Dans certaines applications, telles que les jonctions tunnel magnétique de type BS-pMTJ, il n'est pas possible d'utiliser une telle couche de croissance car l'empilement magnétique doit être déposé au-dessus de la barrière tunnel. Dans de tels cas, il est impossible d'obtenir des empilements magnétiques ayant une forte anisotropie magnétique perpendiculaire en utilisant les empilements connus dans l'état de la technique.

## RESUME DE L'INVENTION

Pour résoudre au moins partiellement les problèmes précédemment cités, un objet de la présente invention est une multicouche ayant une forte anisotropie magnétique perpendiculaire et qui ne nécessite pas d'être déposé sur une couche de croissance ayant une structure cristalline prédéfinie.

A cette fin, un objet de l'invention est une multicouche comprenant au moins un premier empilement magnétique et un deuxième empilement magnétique selon la revendication 1.

On entend par empilement magnétique un empilement de couches, avec au moins une couche ayant des propriétés magnétiques.

On entend par premier élément comprenant une couche ferromagnétique un élément de l'empilement magnétique comprenant une couche ou deux couches superposées, au moins une des deux couches étant ferromagnétique.

Le deuxième élément constitué d'une couche métallique sera indifféremment appelé deuxième élément ou deuxième couche ou simplement couche métallique.

On entend par matériau métallique réfractaire un métal ayant une température de fusion supérieure à 1600°C et de préférence supérieure à 1900°C à la pression de 1 bar.

De façon générale, l'empilement magnétique est du type couche ferromagnétique FM / couche métallique X en présence d'un matériau métallique réfractaire.

La couche métallique est constituée par un matériau métallique apte à conférer à l'ensemble formé par le premier élément magnétique et la deuxième couche une anisotropie magnétique perpendiculaire d'origine interfaciale.

Par exemple, le premier élément comprend un ou plusieurs matériaux pris dans un premier groupe de matériaux, ledit premier groupe de matériaux étant constitué par les matériaux suivants : cobalt, fer, nickel et les alliages magnétiques à base de ces matériaux.

Le deuxième élément comprend un ou plusieurs matériaux pris dans un deuxième groupe de matériaux, ledit deuxième groupe de matériaux étant constitué par les matériaux suivants : platine, or, iridium, palladium, nickel, NiCo, NiFe, NiFeCo et les alliages à base de ces matériaux.

Le matériau métallique réfractaire peut prendre la forme d'une couche d'insertion I séparant la couche ferromagnétique et la deuxième couche métallique, l'empilement magnétique ayant alors la forme couche ferromagnétique FM/couche d'insertion I/deuxième couche métallique X ou FM/I/X. Alternativement, le premier élément peut comprendre une seule couche formée par un alliage d'un des matériaux du premier groupe et d'un matériau métallique réfractaire.

L'empilement magnétique permet d'obtenir une stabilité thermique et une anisotropie magnétique perpendiculaire plus élevée que les empilements connus dans l'état de l'art.

Cela est possible grâce à l'utilisation, dans le premier élément de l'empilement magnétique, d'un matériau métallique réfractaire ayant une température de fusion élevée. Une telle température de fusion élevée reflète le fait que les atomes du matériau réfractaire possèdent des liens chimiques forts et qui résistent lors de l'étape de dépôt du deuxième élément ou deuxième couche X. Grâce à l'utilisation du métal réfractaire il est donc possible de réduire les défauts d'interface créés lors de la croissance de la deuxième couche. Quand il est utilisé en tant que couche d'insertion, le matériau réfractaire permet en outre de lisser les interfaces entre la première couche et la deuxième couche de sorte à augmenter l'anisotropie magnétique perpendiculaire à l'interface. Par ailleurs, l'insertion de couches de métal réfractaire rigidifie mécaniquement l'ensemble de l'empilement ce qui a pour effet d'augmenter sa stabilité lors de recuits éventuels à température élevée comme 400°C.

De plus, la couche d'insertion peut réduire l'aimantation de l'empilement et donc réduire l'énergie démagnétisante. Cela produit une augmentation effective de l'anisotropie magnétique perpendiculaire.

Grace à cet ensemble de propriétés, l'empilement magnétique permet d'obtenir une bonne anisotropie magnétique perpendiculaire sans besoin d'une couche de croissance ayant une texture opportunément choisie pour favoriser l'anisotropie magnétique perpendiculaire.

L'empilement magnétique peut donc être disposé sur plusieurs types de couches de support.

Il s'ensuit que l'empilement magnétique peut être utilisé dans des dispositifs spintroniques qui ne sont pas compatibles avec la présence d'une couche de croissance ayant une texture définie, par exemple une jonction tunnel magnétique de type BS-pMTJ.

De plus, grâce à l'utilisation d'un matériau métallique réfractaire ayant une température de fusion élevée, l'empilement magnétique a une plus grande stabilité thermique. En particulier, grâce à la rigidité mécanique des matériaux réfractaires l'empilement magnétique reste stable jusqu'à 425°C.

L'empilement magnétique peut également présenter une ou plusieurs des caractéristiques ci-après, prises individuellement ou selon toutes les combinaisons techniquement possibles :

- la couche ferromagnétique du premier élément comprend un ou plusieurs matériaux pris dans un premier groupe de matériaux, ledit premier groupe de matériaux étant constitué par les matériaux suivants : cobalt, fer, nickel et les alliages magnétiques à base de ces matériaux ;
- la couche métallique du deuxième élément comprend un ou plusieurs matériaux pris dans un deuxième groupe de matériaux, ledit deuxième groupe de matériaux étant constitué par les matériaux suivants : platine, or, iridium, palladium, nickel, NiCo, NiFe, NiFeCo et les alliages à base de ces matériaux ;
- la couche ferromagnétique du premier élément comprend un alliage d'un ou plusieurs matériaux pris dans le premier groupe de matériaux et d'un matériau métallique réfractaire ;
- le premier élément comprend une première couche du premier élément et une deuxième couche du premier élément, la première couche du premier élément comprenant un ou plusieurs matériaux pris dans le premier groupe de matériaux et la deuxième couche du premier élément étant constituée du matériau métallique réfractaire ;
- le matériau métallique réfractaire est pris dans le groupe suivant : tantale, tungstène, molybdène, ruthénium, zirconium, vanadium, niobium ;
- le matériau métallique réfractaire possède une température de fusion supérieure à 1600 °C, ladite température de fusion étant mesurée à la pression de 1 bar ;
- la deuxième couche du premier élément possède une épaisseur comprise entre 0.1 et 0.6 nm ;
- la deuxième couche du premier élément possède une épaisseur comprise entre 0.2 et 0.4 nm.

Un objet préféré de l'invention est une jonction tunnel magnétique comprenant :

- Une première multicouche magnétique dite couche de référence ;
- Une deuxième multicouche magnétique dite couche de stockage ;
- Une couche barrière tunnel qui sépare la couche de référence et la couche de stockage la couche de référence comprenant une multicouche selon l'une des revendications 1 à 7.

On entend par couche de référence une multicouche magnétique comprenant une couche de piégeage, une couche de transition structurale de symétrie et une couche de polarisation de spin. L'aimantation de la couche de référence est fixe et perpendiculaire au plan des couches.

On entend par couche de stockage une monocouche ou multicouche magnétique ayant une aimantation perpendiculaire au plan de couche, l'orientation de l'aimantation de la couche de stockage étant modifiable par une méthode d'écriture opportunément choisie.

Selon une variante, dans la jonction tunnel magnétique selon l'invention la couche barrière tunnel est placée au-dessus de la couche de stockage pour réaliser une jonction tunnel magnétique de type BS-pMTJ.

Avantageusement, ce type de jonction tunnel magnétique est particulièrement adaptée à une cellule mémoire de type SOT-MRAM.

Un autre objet préféré de l'invention est un point mémoire à deux ou trois terminaux comprenant :

- Une électrode supérieure au contact d'un premier terminal ;
- Une multicouche magnétique dite couche de référence comprenant au moins une multicouche selon selon l'une des revendications 1 à 7 ;
- Une multicouche magnétique dite couche de stockage ;
- Une couche barrière tunnel séparant la couche de référence et la couche de stockage ;
- Un deuxième terminal en contact électrique avec la couche de stockage ou Une ligne métallique reliée électriquement à un deuxième et troisième terminaux, placée au-dessous de la couche de stockage et au contact électrique de la couche de stockage.

Un tel point mémoire à trois terminaux est particulièrement adapté à des cellules mémoire de type SOT-MRAM ou aux mémoires dites « racetrack » ou registres à décalage.

Selon une variante du point mémoire à trois terminaux selon l'invention, la ligne métallique est une ligne métallique antiferromagnétique, l'écriture de la couche de stockage se réalisant alors par propagation des parois des domaines magnétiques. Selon une variante du point mémoire à trois terminaux, la couche de stockage a une géométrie de type « racetrack » ou registre à décalage.

Un autre objet préféré de l'invention est un point mémoire à trois terminaux comprenant :

- Une électrode supérieure connectée à un premier terminal ;
- Une première multicouche magnétique dite couche de référence comprenant au moins une multicouche selon l'une des revendications 1 à 7 ;
- Une multicouche magnétique dite couche de stockage, un deuxième et un troisième terminal étant connectés à ladite couche de stockage ;
- Une couche barrière tunnel séparant la couche de référence et la couche de stockage.

Dans ce cas les contacts électriques sont directement connectés à la couche de stockage.

Un autre objet préféré de l'invention est une double jonction tunnel magnétique comprenant :

- Une première multicouche magnétique dite première couche de référence ;
- Une deuxième multicouche magnétique dite première couche de stockage ;
- Une troisième multicouche magnétique dite deuxième couche de référence comprenant une multicouche magnétique selon l'une des revendications 1 à 7 ;
- Une première couche barrière tunnel séparant la première couche de référence et la couche de stockage ;
- Une deuxième couche barrière tunnel séparant la deuxième couche de référence et la couche de stockage.

Un autre objet préféré de l'invention est une jonction tunnel magnétique pour une cellule mémoire à plusieurs niveaux comprenant :

- Une première multicouche magnétique dite première couche de stockage ;
- Une deuxième multicouche magnétique dite première couche de référence comprenant une multicouche magnétique selon l'une des revendications 1 à 7 ;
- Une première couche barrière tunnel séparant la première couche de référence et la première couche de stockage ;
- Une troisième multicouche magnétique dite deuxième couche de référence ;
- Une quatrième multicouche magnétique dite deuxième couche de stockage ;
- Une deuxième couche barrière tunnel séparant la deuxième couche de référence et la deuxième couche de stockage.

Un autre objet préféré de l'invention est un point mémoire à trois terminaux pour une cellule mémoire à plusieurs niveaux comprenant :

- Une ligne métallique connectée à un deuxième et un troisième terminal ;
- Une première multicouche magnétique dite première couche de stockage placée au-dessus de la ligne métallique et au contact de ladite ligne métallique ;
- Une deuxième multicouche magnétique dite première couche de référence comprenant une multicouche selon l'une des revendications 1 à 7 ;
- Une troisième multicouche magnétique dite deuxième couche de référence ;
- Une quatrième multicouche magnétique dite deuxième couche de stockage ;
- Une électrode supérieure connectée à un premier terminal.

Un autre objet préféré de l'invention est un point mémoire à quatre terminaux pour une cellule mémoire à plusieurs niveaux comprenant :

- Une première ligne métallique connectée à un premier et à un deuxième terminal ;
- Une première multicouche magnétique dite première couche de stockage placée au-dessus de la première ligne métallique et au contact de ladite première ligne métallique ;
- Une deuxième multicouche magnétique dite première couche de référence comprenant une multicouche selon l'une des revendications 1 à 7 ;
- Une première couche barrière tunnel séparant la première couche de stockage et la première couche de référence ;
- Une troisième multicouche magnétique dite deuxième couche de référence ;
- Une quatrième multicouche magnétique dite deuxième couche de stockage ;
- Une deuxième ligne métallique connectée à un troisième et à un quatrième terminal, ladite deuxième ligne métallique étant placée au-dessus de la deuxième couche de stockage et au contact de ladite deuxième couche de stockage ;
- Une deuxième couche barrière tunnel séparant la deuxième couche de stockage et la deuxième couche de référence.

Un autre objet préféré de l'invention est un capteur pour la mesure d'un champ magnétique appliqué comprenant :

- Une électrode supérieure connectée à un premier terminal ;
- Une première multicouche magnétique dite couche de référence comprenant une multicouche selon l'une des revendications 1 à 7 ;
- Une deuxième multicouche magnétique dite couche de détection ayant une aimantation orientée parallèlement au plan des couches en absence de champ magnétique appliqué ;
- Une couche barrière tunnel séparant la couche de détection (Sen) et la couche de référence ;
- Au moins un deuxième terminal relié à la couche de détection.

Selon une variante, le capteur selon l'invention est adapté pour la mesure d'un champ magnétique appliqué et de la température et comprend en outre une ligne métallique connectée à un deuxième et à un troisième terminal, ladite ligne métallique étant au-dessous de la couche de détection et au contact de ladite couche de détection.

## LISTE DES FIGURES

D'autres caractéristiques et avantages de l'invention ressortiront à la lecture de la description qui suit, en référence aux figures annexées, qui illustrent :

- La figure 1a et la figure 1b montrent deux empilements magnétiques selon l'état de l'art et correspondant à une jonction magnétique tunnel avec une couche de référence respectivement au-dessous et au-dessus de la barrière tunnel ;
- La figure 2a montre un empilement magnétique ;
- La figure 2b montre une multicouche selon l'invention comprenant au moins deux empilements selon la figure 2a ;
- La figure 3a montre une jonction tunnel magnétique comprenant une multicouche selon la figure 2b ;
- La figure 3b montre un deuxième mode de réalisation de la jonction tunnel magnétique selon la figure 3a ;
- La figure 4 montre l'anisotropie magnétique perpendiculaire pour des empilements magnétiques selon l'invention ayant différentes couches d'insertion ;
- Les figures 5a et 5b montrent les courbes d'aimantation mesurées pour les empilements dont l'anisotropie magnétique perpendiculaire est montrée à la figure 4 ;
- La figure 6 montre l'aimantation de saturation des empilement magnétiques dont l'anisotropie magnétique perpendiculaire est montrée à la figure 4 ;
- La figure 7 montre l'anisotropie magnétique perpendiculaire pour différents types d'empilements magnétiques selon l'invention ;

- La figure 8 montre la courbe d'aimantation d'une jonction tunnel magnétique selon l'invention ;
- Les figures 9a à 9d montrent différents types de point mémoire selon l'invention ;
- La figure 10 montre une double jonction tunnel magnétique comprenant une couche de stockage composite et comprenant au moins une multicouche selon l'invention ;
- La figure 11 montre une jonction tunnel magnétique comprenant deux couches de stockage et au moins une multicouche selon l'invention ;
- La figure 12 montre un point mémoire à trois terminaux obtenu à partir de la double jonction tunnel illustrée à la figure 11 ;
- La figure 13 montre un point mémoire à quatre terminaux comprenant au moins un empilement magnétique ou une multicouche selon l'invention ;
- La figure 14 montre un exemple de capteur de température et de champ magnétique comprenant une multicouche selon l'invention ;
- La figure 15 montre la résistance électrique mesurée aux bornes d'une ligne métallique en Pt en fonction de la température.

## DESCRIPTION DETAILLEE DE L'INVENTION

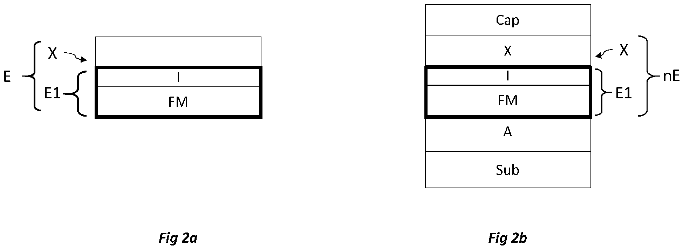

La figure 2a montre un exemple d'empilement magnétique E L'empilement magnétique E comprend un premier élément E1 et un deuxième élément ou deuxième couche X, la deuxième couche X étant placée au-dessus du premier élément E1. Le premier élément E1 peut être une bicouche comme il est illustré à la figure 2a. Dans ce cas le premier élément E1 comprend une première couche FM et une deuxième couche I du premier élément. La première couche FM du premier élément E1 est une couche ferromagnétique comprenant au moins un des matériaux appartenant au premier groupe de matériaux. Le premier groupe de matériaux comprend les matériaux suivants : cobalt, fer, nickel et les alliages magnétiques à base de ces matériaux. Le deuxième élément est ici disposé directement sur le premier élément.

La deuxième couche I du premier élément E1, appelée également couche d'insertion I, est une couche constituée d'un métal réfractaire. La température de fusion de la deuxième couche I du premier élément E1 est supérieure à 1600 °C et de préférence supérieure à 1900 °C.

Selon un autre mode de réalisation non représenté à la figure 2a, le premier élément E1 comporte une seule couche constituée d'un alliage d'un matériau compris dans le premier groupe de matériaux et d'un métal réfractaire.

L'empilement magnétique E comprend en outre un deuxième élément ou deuxième couche X déposée sur le premier élément E1. La deuxième couche X comprend au moins un des matériaux appartenant au deuxième groupe de matériaux. Le deuxième groupe de matériaux comprend les matériaux suivants : Pt, Au, Ir, Pa, Ni, NiCo, NiFe, NiFeCo et les alliages à base de ces matériaux.

La deuxième couche I du premier élément magnétique est une couche ayant plusieurs buts :

- éviter la formation de défauts dans la couche FM lors du dépôt de la couche X souvent réalisée en matériaux lourds comme le Pt ou le Pd ;
- permettre d'obtenir une interface de faible rugosité entre la couche FM et X ce qui a pour effet d'augmenter l'anisotropie perpendiculaire de l'empilement E ;
- réduire l'aimantation à saturation de la couche de matériau FM ce qui contribue à augmenter l'anisotropie perpendiculaire effective ;
- améliorer la stabilité structurale de l'ensemble de l'empilement lors des recuits éventuels à haute température comme 400°C grâce à la rigidification mécanique introduite par l'insertion de la couche réfractaire I.

Des exemples de métaux réfractaires pour la deuxième couche I du premier élément E1 sont : tantale, tungstène, molybdène, ruthénium, zirconium, vanadium, niobium.

Selon le mode de réalisation illustré à la figure 2a, l'empilement magnétique possède une structure du type FM/I/X.

Il est important de noter que les matériaux utilisés pour la couche d'insertion I ont des températures de fusion plus élevées que les autres couches d'insertion métallique connues dans l'état de l'art. Par exemple, les métaux divulgués dans la demande de brevet FR 2976396 ont des températures de fusion de l'ordre de 1000°C ou inférieures. De tels matériaux ne sont pas considérés des matériaux réfractaires au sens de la présente demande.

La figure 2b montre une multicouche selon l'invention comprenant :

- Une couche de substrat Sub ;
- Une couche d'adhésion A ;
- une multicouche nE formée par des empilements magnétiques E selon la figure 2a ;

- Une couche de protection Cap.

La multicouche nE est obtenue en superposant au moins deux empilements E. Lors de la superposition, le premier élément E1 d'un deuxième empilement magnétique E est déposée sur la deuxième couche X d'un premier empilement E.

Dans l'exemple illustré à la figure 2b, la multicouche nE est déposée sur une couche conductrice d'adhésion A. La couche conductrice d'adhésion A peut être en Ta avec une épaisseur comprise entre 3 et 5 nm. Le Ta peut être remplacé par tout autre matériau apte à fournir une bonne adhésion avec le substrat Sub et garder une interface supérieure de faible rugosité.

La couche A peut également avoir le rôle d'électrode inférieure pour réaliser un contact électrique à la base de la structure.

Alternativement, une telle électrode inférieure peut être réalisée en CuN, TiN, TaN ou Ru. L'électrode inférieure peut également être une multicouche formée par la répétition d'une bicouche CuN/Ta.

Pour améliorer les propriétés magnétiques de la multicouche nE selon l'invention, la rugosité de la surface de cette couche peut être réduite par polissage mécanochimique suivi d'une faible gravure de la couche superficielle.

La couche A ou l'électrode inférieure peut être placée sur une couche de substrat Sub. Pour prévenir l'oxydation de la multicouche nE selon l'invention, une couche de protection Cap est déposée sur la deuxième couche X. La couche de protection Cap peut être également utilisée comme contact électrique supérieur.

Selon un mode de réalisation, la couche ferromagnétique du premier élément E1 est réalisée en Cu. Toutefois la couche Fm peut également comprendre CoFe, Fe, Ni ou un alliage de ces matériaux. La couche FM peut également comprendre un élément non magnétique tel que CR, V, B ou Zr.

La deuxième couche X de l'empilement magnétique E peut comprendre un des matériaux suivants : Pt, Pd, Ru, Au, Ir, Ni, NiCo, NiFe ou une combinaison de ces matériaux.

La deuxième couche I du premier élément E1 est constituée d'un métal réfractaire tel que Ta, W, Ru, Mo, Nb, V, Zr ou une combinaison de ces matériaux. Les températures de fusion de ces matériaux sont respectivement 3020°C, 3422°C, 2334°C, 2623°C, 2469 °C, 1910°C, 1855°C. Ces températures de fusion sont mesurées à la pression de 1 bar.

Quand le premier élément E1 est une monocouche, il s'agit d'un alliage composé d'un des matériaux ferromagnétiques donnés plus haut et d'un métal réfractaire tel que Ta, Mo, W, Ru, Nb, V ou Zr.

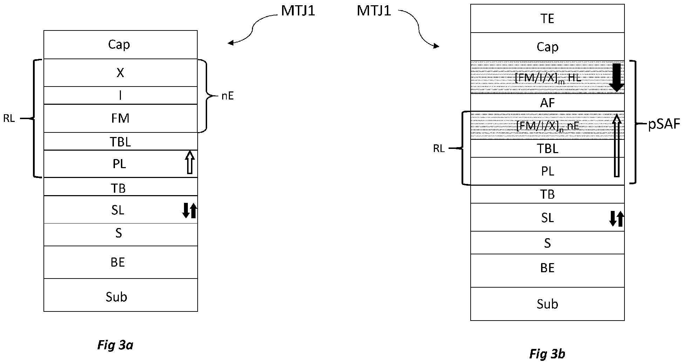

La figure 3a montre une jonction tunnel magnétique MTJ1 selon l'invention comprenant :

- Une couche de substrat Sub ;
- Une couche d'électrode inférieure BE ;
- Une couche de croissance S ;
- Une couche de stockage SL ;
- Une couche barrière tunnel TB, de préférence en MgO ;
- Une couche de polarisation de spin PL, de préférence en FeCoB ;
- Une couche de transition structurale de symétrie, TBL ;
- Une multicouche nE selon l'invention ;
- Une couche de protection Cap.

La couche de polarisation de spin PL, la couche de transition structurale de symétrie TBL et la multicouche nE selon l'invention forment la couche de référence RL. La couche de référence RL peut également être considérée comme une électrode magnétique supérieure. La couche barrière tunnel sépare la couche de référence RL et la couche de stockage SL. La couche de stockage SL peut être une monocouche ou une multicouche magnétique.

La couche de stockage SL est de préférence en CoFeA, A étant un élément amorphisant par exemple B, Zr ou Nb. La couche de stockage SL se trouve au-dessus de la couche de croissance S, qui absorbe l'élément amorphisant A pendant le recuit à une température comprise entre 250°C et 450°C. Quand une barrière tunnel BT en MgO est utilisée, le recuit induit une recristallisation de la couche de stockage SL. A cause de cette recristallisation la couche de stockage en CoFeA amorphe se transforme en CoFe ayant une symétrie cubique centrée (bcc).

Placée au-dessus de la barrière tunnel, l'électrode magnétique supérieure ou couche de référence RL est formée par une couche de polarisation de spin PL en CoFeB, une couche de transition structurale de symétrie TBL et la multicouche nE selon l'invention. Comme il est connu dans l'art antérieur, la couche TBL de transition structurale de symétrie assure la transition structurale entre la structure crystalline bcc de la couche de polarisation PL après recuit et la structure crystalline fcc du multicouche nE selon l'invention.

En particulier, la multicouche nE ne nécessite pas d'être au contact d'une couche de croissance S pour garder une aimantation stable orientée hors du plan des couches pendant toute la durée de vie du dispositif. Cela est possible grâce à la forte anisotropie magnétique perpendiculaire propre de la multicouche nE selon l'invention. La multicouche nE peut donc être insérée dans une couche de référence au-dessus de la barrière tunnel BT et utilisée dans une jonction tunnel magnétique de type « bottom storage » ou BS-pMTJ telle que celle illustrée à la figure 3a.

Avantageusement, une jonction magnétique tunnel BS-pMTJ peut être utilisée pour réaliser un point mémoire de type SOT-MRAM, dans lequel la couche de stockage SL doit être à proximité de l'électrode inférieure.

Selon une variante de la jonction tunnel magnétique MTJ1 selon l'invention, la couche de référence RL peut être insérée dans un élément antiferromagnétique synthétique perpendiculaire pSAF comme illustré à la figure 3b. Dans ce cas une couche de couplage antiferromagnétique AF telle que celle représentée à la figure 3b est utilisée. Cette couche de couplage AF peut être en Ru avec une épaisseur comprise entre 0.3nm et 0.9nm. Un deuxième empilement nE de type $(FM/I/X)_m$ selon l'invention est placé au-dessus de la couche de couplage et couvert par une couche de protection Cap. Une couche d'électrode supérieure TE est déposée au-dessus de la couche protectrice Cap.

Dans une jonction tunnel magnétique de type BS-pMTJ selon l'invention, la couche de piégeage peut être constituée par une multicouche nE selon l'invention, par exemple du type $(FM/I/X)_n$, à savoir n répétitions de l'empilement FM/I/X ou empilement E selon l'invention.

La couche dure HL peut être constituée par une multicouche simple du type $(FM/X)_m$, avec m et n étant ajustés en tenant compte des épaisseurs des couches FM dans les deux multicouches nE et HL pour minimiser le champ parasite exercé par la couche synthétique antiferromagnétique pSAF sur la couche de stockage SL. Alternativement, la couche dure peut être également constituée par une multicouche selon l'invention de type $(FM/I/X)_n$. En effet, l'utilisation d'une multicouche selon l'invention pour la couche dure permet d'augmenter l'anisotropie magnétique perpendiculaire.

Alternativement la couche dure HL peut être réalisée en un matériau « bulk » ayant une anisotropie magnétique perpendiculaire. Des exemples de tels matériaux sont des alliages ayant une symétrie de type $L1_0$ tels que Fe-Pt, Fe-Pd et Co-Pt. Alternativement, il est possible d'utiliser des matériaux ayant une symétrie $L1_1$ tels que CoPt, CoPd ou Co-Ni-Pt.

La couche dure HL peut également être réalisée en utilisant un alliage d'une terre rare et d'un métal de transition RE-TM. Parmi les terres rares, on pourra particulièrement choisir un élément dans le groupe formé par Tb, Dy, Ho, Er ou un mélange de ces éléments. On entend par métal de transition un élément tel que Fe, Co ou un mélange de ces éléments. Alternativement un alliage de type Heusler avec anisotropie perpendiculaire peut être utilisé, par exemple $Mn_{2.7}Co_{0.3}Ga$.

La couche dure HL et la couche de référence RL sont couplées antiferromagnétiquement par une couche de couplage AF, par interaction RKKY. La couche de couplage AF peut être réalisée en Ru, Re, Rh, Ir, Os ou un mélange de ces éléments.

La barrière tunnel TB est réalisée en MgO. Toutefois d'autres oxydes métalliques peuvent également être utilisés, tels que $AlO_x$, $TaO_x$, $TiO_2$, $HfO_x$, $ZrO_x$, $GaO_x$, SrTiOs.

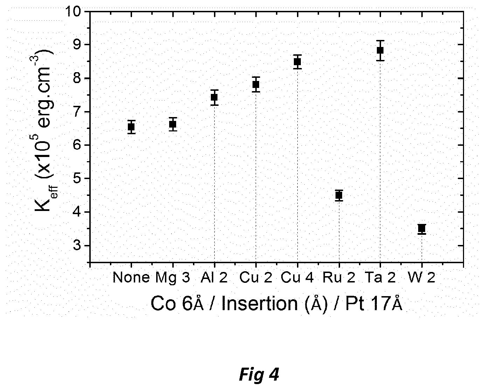

La figure 4 montre l'anisotropie magnétique perpendiculaire Keff d'une multicouche nE selon l'invention formée par la répétition de cinq empilements magnétiques E selon l'invention.

Chacun des cinq empilements comprend :

- une première couche ferromagnétique FM du premier élément E1 en Co et ayant une épaisseur de 0.6 nm ;
- une deuxième couche I du premier élément E1 en matériau métallique réfractaire, chaque point du graphe en figure 4 correspondant à un matériau différent ;
- une deuxième couche X en Pt et ayant une épaisseur de 1.7 nm.

En d'autres termes, la multicouche nE étudiée à la figure 4 possède la structure $(CO/I/Pt)_5$.

Les cinq empilements sont insérés dans la partie supérieure d'une jonction tunnel magnétique MTJ1 comme celle illustrée à la figure 3. La jonction tunnel magnétique a été soumise à un recuit à 400°C.

Le graphe de figure 4 montre en ordonnée l'anisotropie magnétique perpendiculaire et en abscisse les différents matériaux choisis pour la couche d'insertion I, ainsi que l'épaisseur en Å de la couche d'insertion I. Chaque point du graphe à la figure 4 représente l'anisotropie magnétique perpendiculaire d'un empilement magnétique de type Sub/Couche d'adhésion en Ta/Couche de polarisation en CoFeB/Barrière tunnel en MgO/ Couche en FeCoB/ Couche de transition structurale de symétrie TBL/ $(Co/I/Pt)_5$/ Couche de protection Cap.

Comme il est connu de l'homme du métier, Keff est calculée à partir de la surface comprise entre les courbes d'hystérésis M(H) mesurées respectivement avec le champ appliqué perpendiculairement au plan des couches et parallèlement au plan des couches. On entend par courbe d'hystérésis M(H), une mesure de l'aimantation M des couches en fonction d'un champ magnétique externe appliqué H.

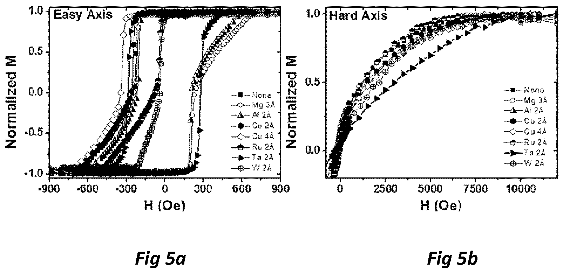

La courbe d'aimantation M(H) relative à l'aimantation perpendiculaire au plan de couches est illustrée à la figure 5a. La courbe d'aimantation M(H) relative à l'aimantation parallèle au plan des couches est illustrée à la figure 5b.

Le graphe de figure 4 montre que l'anisotropie magnétique perpendiculaire Keff mesurée en présence d'une couche d'insertion en Al, Cu ou Ta est plus élevée que celle mesurée sans couche d'insertion. En particulier, l'utilisation du métal réfractaire Ta donne l'anisotropie magnétique perpendiculaire Keff la plus élevée.

L'anisotropie magnétique perpendiculaire par unité de volume Keff pour une multicouche de type $(Co/I/Pt)_n$ peut être calculée grâce à l'équation suivante :

$$K_{eff} = \frac{K_{FeCoB}}{t_{FeCoB}} + (n-1)\frac{K_{Pt-Co}}{t_{Co-Pt}} + n\frac{K_{Co-I-Pt}}{t_{Co-Pt}} - 2\pi M_s{}^2$$

Dans cette équation, en unités CGS :

- n est le nombre d'empilements (Co/I/Pt) superposés ;
- $K_{Pt-Co}$ et $K_{Co-I-Pt}$ sont les constantes d'anisotropie d'interface aux interfaces Pt-Co et Co-I-Pt respectivement ; ces constantes sont exprimées en densité surfacique d'énergie ;
- $K_{FeCoB}$ est l'anisotropie d'interface à l'interface entre MgO et FeCoB ;
- $M_S$ est l'aimantation de saturation ;
- $t_{Co-Pt}$ est l'épaisseur totale des couches en Pt et Co.

La valeur élevée de Keff obtenue pour une couche I en Cu s'explique par la faible miscibilité du Cu avec le Co, comme il a été expliqué dans le document FR 2976396. Toutefois, l'utilisation d'une couche d'insertion en Ta augmente ultérieurement l'anisotropie magnétique perpendiculaire, comme il est illustré à la figure 4. Cela s'explique par la grande rigidité de l'élément réfractaire Ta et la présence de liens chimiques très forts qui empêchent la création de défaut de surface pendant le dépôt de la couche en métal lourd par exemple Pt.

La figure 5a montre que la courbe d'aimantation perpendiculaire M(H) de la multicouche comprenant une couche en Ta possède des transitions plus abruptes que la courbe relative à une multicouche comprenant une couche en Cu ou un autre métal non réfractaire. De plus, la figure 5b montre que la courbe d'aimantation planaire M(H) relative à l'empilement comprenant une couche en Ta est presque linéaire. Un tel comportement linéaire de M(H) lorsque le champ est appliqué perpendiculairement à l'axe facile d'aimantation suggère que l'anisotropie est de caractére uniaxial (anisotropie d'ordre 2) comme il est connu de l'homme de l'art. Par contre, pour les autres matériaux utilisés, les courbes M(H) mesurées avec le champ appliqué dans le plan des couches présentent une courbure prononcée. Ceci suggère que l'anisotropie perpendiculaire possède des termes d'anisotropie d'ordre supérieur à l'ordre uniaxial (en particulier des termes d'anisotropie d'ordre 4).

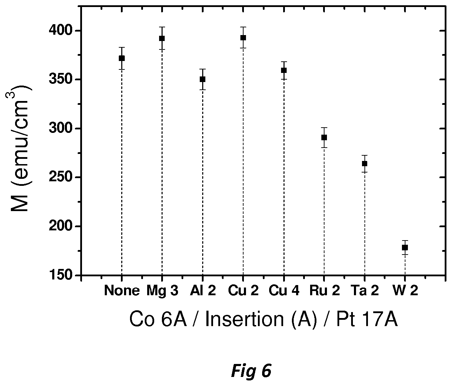

D'après l'équation donnée plus haut, l'anisotropie magnétique perpendiculaire Keff augmente quand l'énergie démagnétisante $2\pi M_s{}^2$ est faible. La figure 6 montre l'aimantation de saturation Ms pour différentes couches d'insertion I dans une multicouche de type Co/I/Pt. Il apparait que pour une couche d'insertion I en Ta, une contribution à la valeur de Keff élevée est due à la réduction de l'aimantation Ms de saturation.

On peut résumer les quatre effets techniques obtenus en rajoutant une couche d'insertion I entre une première couche ferromagnétique FM du premier élément E1 et une deuxième couche X de l'empilement magnétique E selon l'invention :

- le mélange entre les atomes du premier élément E1 et les atomes de la deuxième couche métallique X est réduit ;
- réduction de l'aimantation de l'empilement E ;
- lissage de l'interface entre le premier élément E1 et la deuxième couche métallique X.
- augmentation de la stabilité structurale de l'ensemble de l'empilement E lors des recuits éventuels à haute température comme 400°C grâce à la rigidification mécanique introduite par l'insertion de la couche réfractaire I.

Ces effets techniques sont également présents quand le premier élément magnétique est une monocouche comprenant un alliage d'un ou plusieurs matériaux pris dans le premier groupe de matériaux et d'un métal réfractaire.

Ces effets techniques permettent d'obtenir une anisotropie magnétique perpendiculaire plus élevée que dans les empilements connus.

Il est important de noter que si l'ordre des couches est renversé et la couche ferromagnétique FM est déposée au-dessus de la deuxième couche X, l'introduction d'une couche d'insertion I au-dessus de la couche X réduirait l'anisotropie magnétique perpendiculaire Keff. Pour cette raison les effets techniques mentionnés plus haut se retrouvent aussi dans le cas d'une multicouche nE obtenue par superposition de plusieurs empilements magnétiques E.

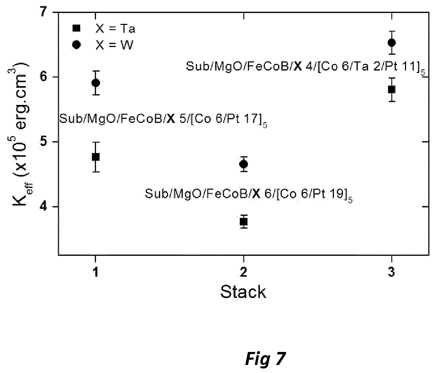

La couche de transition structurale de symétrie BTL joue également un rôle dans l'augmentation de l'anisotropie magnétique perpendiculaire. La figure 7 montre l'anisotropie magnétique perpendiculaire Keff mesurée pour trois types d'empilements différents, chaque empilement étant réalisé en deux variantes : une variante avec une couche de transition structurale de symétrie en Ta et une variante avec une couche de transition structurale de symétrie en W.

Le graphe de figure 7 montre clairement qu'une couche de transition structurale de symétrie en W comporte systématiquement des valeurs de Keff plus élevées.

D'autres matériaux possibles pour la couche de transition structurale de symétrie TBL sont W, Mo, Hf, Zr, Nb.

Avantageusement, la multicouche nE selon l'invention peut être utilisée pour la réalisation d'une jonction tunnel magnétique à aimantation perpendiculaire MTJ1 selon l'invention. La multicouche nE permet d'obtenir une anisotropie magnétique perpendiculaire élevée, même en absence d'une couche de croissance S ayant une symétrie prédéterminée.

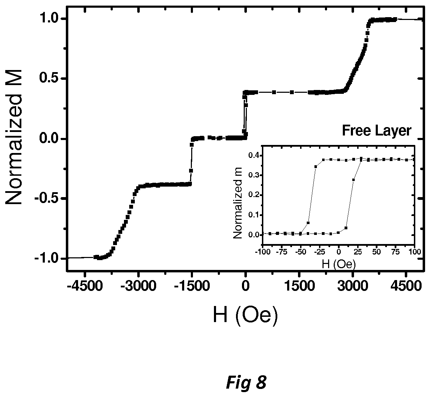

La figure 8 montre la courbe d'aimantation M en fonction du champ magnétique externe H appliqué pour une jonction magnétique tunnel de type BS-pMTJ. En particulier, la jonction tunnel magnétique étudiée à la figure 8 est du type illustré à la figure 3b, dans laquelle la couche de piégeage comprise dans la couche de référence

RL est une multicouche nE de type $(FM/X/I)_n$ selon l'invention. En partant d'une valeur de H positive et élevée et en diminuant progressivement H, on observe l'inversion de l'aimantation de la couche de référence pour H=3kOe. Successivement on observe l'inversion de l'aimantation de la couche de stockage pour une valeur de H légèrement négative. Pour un champ H=-1.5kOe on observe l'inversion simultanée de l'aimantation de la couche de référence et de la couche dure. L'aimantation de la couche de référence s'oriente selon le champ H négatif pour H=-3.35kOe. L'encart dans la figure 8 montre en détail l'inversion de l'aimantation de la couche de stockage SL pour un champ magnétique appliqué H proche de zéro.

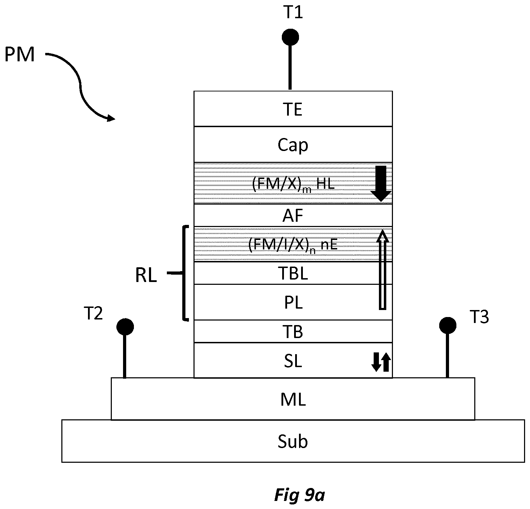

Les figures 9a à 9d montrent des points mémoire à trois terminaux pour une cellule mémoire magnétique à accès aléatoire de type « couple spin orbite» ou SOT-MRAM. Ces points mémoire peuvent être utilisés également pour une mémoire de type racetrack. Ces points mémoire sont obtenus à partir d'une jonction tunnel magnétique de type BS-pMTJ selon l'invention.

Le dispositif de figure 9a comprend :

- une électrode supérieure TE placée au-dessus d'une couche de protection Cap de la jonction tunnel ;
- une couche dure HL ;
- une couche de couplage antiferromagnétique AF ;
- une couche de référence RL comprenant une multicouche nE selon l'invention, une couche de transition structurale de symétrie TBL, une couche de polarisation de spin PL ;
- une barrière tunnel TB ;
- une couche de stockage SL ;
- une ligne métallique ML conductrice placée au-dessous de la couche de stockage SL;
- une couche de substrat Sub placée au-dessous de la ligne métallique ML ;
- un premier terminal T1 au contact de l'électrode supérieure ;
- un deuxième T2 et un troisième T3 terminal au contact de la ligne métallique.

A la différence des mémoires magnétique de type STT-MRAM, qui comprennent deux terminaux, les mémoires de type SOT-MRAM comprennent trois ou quatre terminaux permettant de séparer les chemins de courant de lecture et d'écriture.

Pour une mémoire de type SOT-MRAM l'opération d'écriture s'effectue par une impulsion de courant circulant dans la ligne métallique ML qui a donc le rôle d'électrode inférieure de la jonction tunnel magnétique. L'opération d'écriture peut exploiter l'effet Rashba ou l'effet Hall de spin (ou Spin Hall Effect, SHE, selon la terminologie anglaise). Si l'effet Hall de spin est utilisé, la ligne métallique ML comprend un métal lourd tel que Pt, Ta ou W. Quand un courant d'électrons parcourt cette ligne métallique entre les terminaux T2 et T3, un courant de spin est injecté par la ligne métallique ML dans la couche de stockage à cause de l'effet Hall de spin. Ce courant de spin exerce un couple spin-orbite sur l'aimantation de la couche de stockage SL. Si le couple exercé par le courant de spin est suffisamment élevé, l'aimantation de la couche de stockage SL est inversée. Grâce au fait que le courant d'écriture ne traverse pas la barrière tunnel TB, l'endurance à l'écriture d'un point mémoire de type SOT-MRAM est plus élevée que celle d'un point mémoire de type STT-MRAM, surtout pour des impulsions de courant de durée inférieure à quelques ns. Par endurance à l'écriture, on entend le nombre de cycles d'écriture que le dispositif peut endurer avant que ses propriétés ne soient dégradées en particulier du fait du claquage diélectrique de la barrière tunnel.

En reversant la direction du flux de courant entre les terminaux T2 et T3, la direction du couple exercé sur l'aimantation de la couche de stockage SL est aussi inversée. Il est donc possible d'inverser à nouveau l'aimantation de la couche de stockage SL.

Le métal choisi pour la ligne métallique ML est un métal caractérisé par un angle de Hall de spin élevé, par exemple Ta, W, Pd, Pt, Au, Ir, Bi ou un alliage de type CuIr, CuBi, CuAu, AuW, IrMn. La ligne métallique ML peut également être une bicouche ou une multicouche formée par un empilement de ces matériaux.

Selon un mode de réalisation du dispositif illustré à la figure 9a, la couche dure HL peut également comprendre une multicouche nE selon l'invention.

L'écriture du point mémoire illustré à la figure 9a repose sur l'utilisation d'impulsions de courant circulant entre le deuxième T2 et le troisième terminal T3. Cette méthode est adaptée à un point mémoire ayant deux états possibles de la couche de stockage SL.

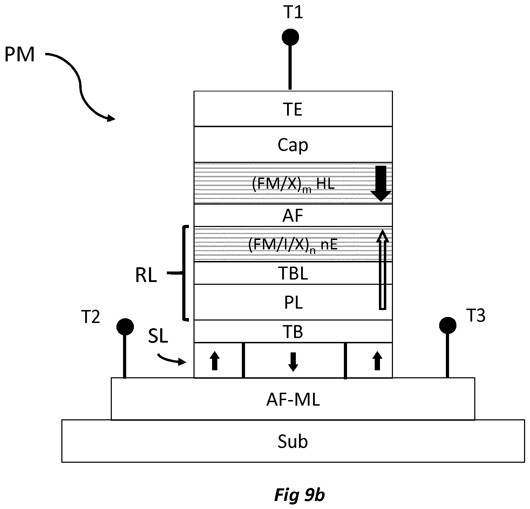

Alternativement l'inversion de l'aimantation de la couche de stockage SL peut se faire progressivement en passant à travers une série d'états ayant des valeurs de résistance intermédiaires. Ce mode de réalisation du point mémoire selon l'invention est illustré à la figure 9b.

Le dispositif de figure 9b diffère du dispositif de figure 9a en ce que la ligne métallique est une ligne métallique antiferromagnétique AF-ML. Le matériau dont la ligne métallique antiferromagnétique est constituée est par exemple IrMn ou PtMn.

A l'interface entre le matériau ferromagnétique dont la ligne métallique AF-ML est constituée et la barrière tunnel TB, l'effet Hall de spin est combiné avec un effet d'anisotropie d'échange. Grâce à l'effet combiné de SHE et d'anisotropie d'échange à l'interface ligne métallique/couche de stockage, l'aimantation de la couche de stockage ne s'inverse pas de façon abrupte mais par création de petits domaines inversés et par propagation des parois de ces domaines. L'anisotropie d'échange augmente aussi le champ coercitif de la couche de stockage et l'inversion de l'aimantation devient progressive. Voir par exemple S. Fukami et al. « Magnetization switching by spin-orbit torque in an antiferromagnet-ferromagnet bilayer system", publié dans Nature Materials, vol. 15, pages 535-541, 2016.

En contrôlant l'amplitude et la durée des impulsions de courant circulant dans la ligne métallique antiferromagnétique AF-ML il est possible d'obtenir plusieurs états ayant des valeurs de magnétorésistance intermédiaires. Ce type de dispositif peut être utilisé aussi pour des applications de type memristor.

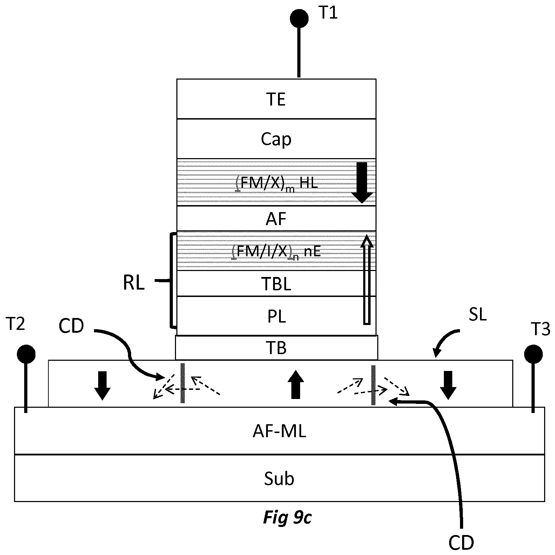

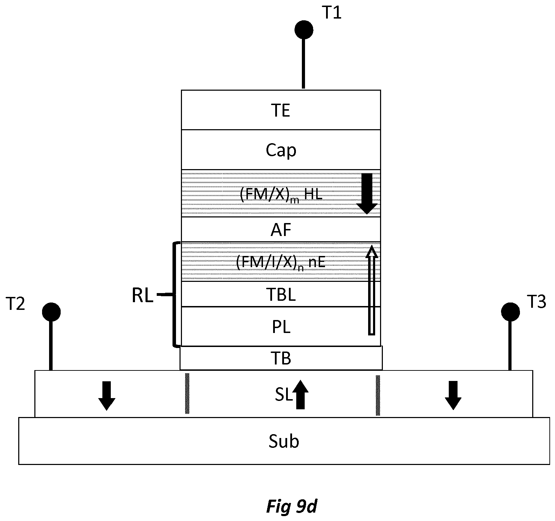

Les figures 9c et 9d montrent des points mémoire à trois terminaux pour des mémoires de type racetrack. Pour une description de ce type de mémoires, voir par exemple « Magnetic domain-wall racetrack memory » de S.S. Parkin et al., publié dans Science, vol 320.5873, pages 190-194, 2008.

Le point mémoire de figure 9c a une structure similaire à celle du dispositif de figure 9b à la différence de la couche de stockage SL qui possède une forme allongée selon une géométrie de type racetrack. La couche de stockage du point mémoire de figure 9c a une surface plus grande que la couche barrière tunnel TB. La ligne métallique AF-ML est en matériau antiferromagnétique comme dans le dispositif de la figure 9b. Le matériau choisi pour la ligne AF-ML est à base de métal lourd comme IrMn ou PtMn de sorte qu'il génère des interactions de Dzyaloshinski Moriya dans la couche de stockage adjacente. Comme il est connu de l'homme de l'art, ceci permet d'obtenir dans la couche SL des parois magnétiques chirales (CD) c'est-à-dire possédant toutes le même sens de rotation. La variation de l'aimantation de la couche de stockage SL est alors réalisée par translation des parois de domaine le long de la racetrack. La translation des parois est réalisée par effet Hall de spin.

Dans le dispositif de figure 9d, la ligne métallique a été éliminée. Les deuxième T2 et troisième terminal T3 sont connectés directement à la couche de stockage SL. La variation d'aimantation de la couche de stockage SL se fait par translation des parois de domaines le long de la racetrack. La translation des parois des domaines se fait par transfert de spin comme dans le dispositif de figure 9b.

Dans les dispositifs de figures 9c et 9d la direction de translation des parois dépend de la polarité des impulsions de courant circulant entre les deuxième et troisième terminal.

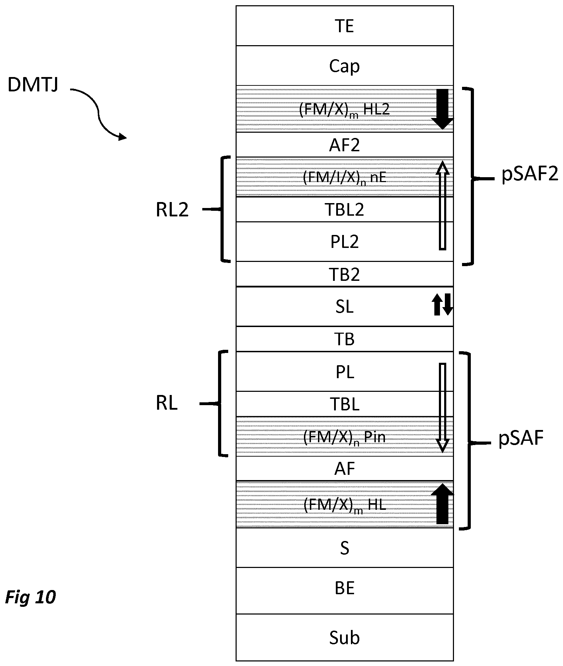

La figure 10 illustre une double jonction magnétique tunnel DMTJ comprenant une multicouche nE selon l'invention.

La double jonction magnétique tunnel DMTJ selon l'invention comprend :

- une couche de substrat Sub ;
- une électrode inférieure BE ;
- une couche de croissance S ;
- une couche dure HL ;
- une couche de couplage antiferromagnétique AF ;
- une première couche de piégeage Pin ;
- une première couche de transition structurale de symétrie TBL ;
- une première couche de polarisation de spin PL ;
- une première barrière tunnel TB ;
- une couche de stockage SL ;
- une deuxième barrière tunnel TB2 ;
- une deuxième couche de polarisation de spin PL2 ;
- une deuxième couche de transition structurale de symétrie TBL2 ;
- une multicouche selon l'invention nE agissant en tant que deuxième couche de piégeage ;
- une deuxième couche de couplage antiferromagnétique AF2 ;
- une deuxième couche dure HL2 ;
- une couche protectrice Cap ;
- une électrode supérieure TE.

La première couche de référence RL est formée par la première couche de piégeage Pin, la première couche de transition structurale de symétrie TBL et la première couche de polarisation de spin PL. La première couche de référence RL est couplée à la première couche dure HL à l'aide d'une première couche de couplage antiferromagnétique AF pour former une première couche antiferromagnétique synthétique pSAF à aimantation perpendiculaire.

La deuxième couche de référence RL2 est formée par la deuxième couche de polarisation PL2, la deuxième couche de transition structurale de symétrie TBL2 et une multicouche nE selon l'invention agissant en tant que deuxième couche de piégeage. La deuxième couche de référence RL2 est couplée à la deuxième couche dure HL2 à l'aide d'une deuxième couche de couplage antiferromagnétique AF2 pour former une deuxième couche antiferromagnétique synthétique pSAF2 à aimantation perpendiculaire.

L'utilisation des deux couches ferromagnétiques synthétiques pSAF et pSAF2 permet de renforcer la coercivité des couches PL et PL2 et de réduire le couplage magnétostatique entre les couches de référence et la couche de stockage SL.

La couche de stockage SL peut être une couche composite comprenant un empilement couche ferromagnétique/couche non magnétique/couche ferromagnétique dans lequel les aimantations des deux couches ferromagnétiques sont fortement couplées par la couche non-magnétique. L'épaisseur de la couche non magnétique détermine le type de couplage ferromagnétique ou antiferromagnétique entre les deux couches ferromagnétiques. La couche de couplage non magnétique peut être en Ta, W ou Mo avec une épaisseur comprise entre 0.1 nm et 1 nm.

Grâce à la présence des deux couches de polarisation de spin PL et PL2 d'aimantation orientée antiparallèlement l'une par rapport à l'autre, le couple de transfert de spin agissant sur l'aimantation de la couche de stockage SL est plus efficace. En particulier, l'efficacité du couple de transfert de spin est plus que doublé par rapport à une jonction tunnel magnétique de type BS-pMTJ ou TS-pMTJ.

Quand la couche de stockage est une couche ferromagnétique composite, l'aimantation de la première couche de référence doit être orientée antiparallèlement à l'aimantation de la deuxième couche de référence pour pouvoir obtenir un effet de transfert de spin (ou Spin Transfer Torque STT selon la terminologie anglaise) efficace. Au contraire, si la couche de stockage SL est une couche antiferromagnétique synthétique c'est-à-dire comprenant deux couches ferromagnétiques couplées de façon antiferromagnétique, l'aimantation de la première couche de référence RL doit être parallèle à l'aimantation de la deuxième couche de référence RL2 pour maximiser l'effet de transfert de spin.

L'orientation parallèle ou antiparallèle des deux aimantations peut être obtenue en réalisant des boucles d'hystérésis et en exploitant la différence entre les champs coercitifs des deux couches de référence.

Selon la variante de double jonction tunnel magnétique DJTM illustrée à la figure 10, la deuxième couche de piégeage, placée au-dessus de la couche de stockage SL, est réalisée en utilisant la multicouche nE selon l'invention et en particulier une multicouche de type $(FM/I/X)_n$. La première couche de piégeage Pin et les deux couches dures HL et HL2 sont réalisées en utilisant une multicouche standard de type $(FM/X)_{n,m}$. Dans la configuration $(FM/X)_n$ pour les couches dures, la couche FM est constituée d'un matériau pris dans le groupe de matériaux comprenant : Co, CoFe, Fe, Ni ou un mélange de ces matériaux. La couche FM peut également comprendre un élément non magnétique tel que Cr, V, B ou Zr. La couche X est constituée d'un matériau pris dans le groupe de matériaux comprenant : Pt, Pd, Ru, Au, Ir, Ni, NiCo, NiFe ou un mélange de ces matériaux.

Selon une variante de double jonction tunnel magnétique DJTM non représentée, les couches dures HL et HL2 peuvent être réalisées en utilisant une multicouche nE selon l'invention de type $(FM/I/X)_m$ et la première couche de piégeage Pin peut aussi être réalisée en utilisant un multicouche nE selon l'invention de type $(FM/I/X)_n$.

Dans toutes les variantes de la double jonction magnétique tunnel DMTJ selon l'invention, la première et deuxième barrière tunnel, TB et TB2, doivent avoir des produits résistance*surface différents. En effet la magnétorésistance tunnel de la première barrière est opposée à celle de la deuxième barrière. Une différence entre les deux barrières tunnel est donc nécessaire pour que la valeur effective de magnétorésistance ne soit pas inférieure à celle obtenue pour une jonction tunnel simple.

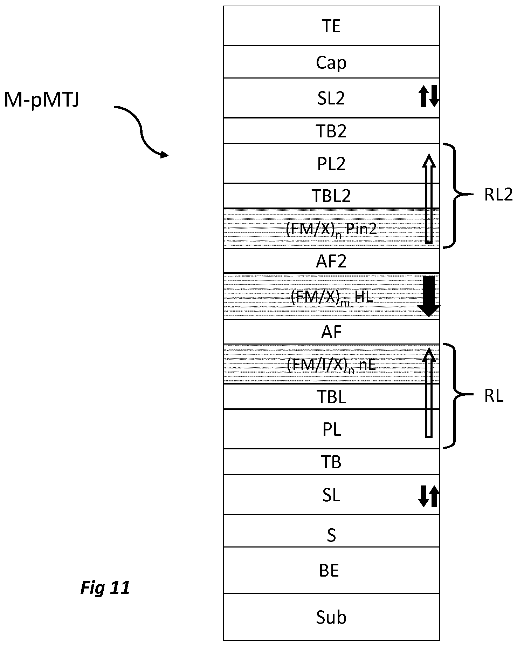

La figure 11 montre une jonction tunnel magnétique à plusieurs niveaux M-pMTJ pour la réalisation d'un point mémoire avec une densité d'information plus élevée qu'un point mémoire standard.

La jonction tunnel magnétique à plusieurs niveaux M-pMTJ de figure 11 comprend :

- une couche de substrat Sub ;
- une électrode inférieure BE ;
- une couche de croissance S ;
- une première couche de stockage SL ;
- une première barrière tunnel TB ;
- une première couche de polarisation de spin PL ;
- une première couche de transition structurale de symétrie TBL ;
- une première couche de piégeage réalisée à l'aide d'une multicouche nE selon l'invention ;
- une première couche de couplage antiferromagnétique AF ;
- une première couche dure HL ;
- une deuxième couche de couplage antiferromagnétique AF2 ;
- une deuxième couche de piégeage Pin2 ;
- une deuxième couche de transition structurale de symétrie TBL2;

- une deuxième couche de polarisation de spin PL2 ;
- une deuxième barrière tunnel TB2 ;
- une deuxième couche de stockage SL2 ;
- une couche de protection Cap ;
- une électrode supérieure TE.

La première couche de polarisation PL, la première couche de transition structurale de symétrie TBL et la multicouche selon l'invention nE agissant en tant que première couche de piégeage constituent la première couche de référence RL.

La deuxième couche de polarisation PL2, la deuxième couche de transition structurale de symétrie TBL et la deuxième couche de piégeage Pin2 constituent la deuxième couche de référence RL2.

La couche dure HL est couplée antiferromagnétiquement aux deux couches de référence RL et RL2.

Selon une variante du dispositif de figure 11, la deuxième couche de piégeage Pin2 peut également comprendre une multicouche nE selon l'invention.

La jonction tunnel magnétique à plusieurs niveaux M-pMTJ comprend deux couches de stockage. La première couche de stockage SL est au-dessous de la première barrière tunnel BT, la deuxième couche de stockage SL2 est au-dessus de la deuxième barrière tunnel TB2. En choisissant deux couches barrière tunnel ayant deux valeurs différentes de leur produit résistance*surface, il est possible d'obtenir quatre valeurs de résistance correspondant aux quatre différentes configurations des aimantations des couches de stockage. Les quatre configurations correspondent aux orientations parallèle/parallèle, parallèle/antiparallèle, antiparallèle/parallèle, antiparallèle/antiparallèle.

Le courant critique d'inversion de l'aimantation doit être différent pour les deux couches de stockage pour pouvoir écrire sélectivement l'une ou l'autre des couches de stockage. Pendant l'écriture de la couche de stockage ayant le champ coercitif le plus élevé, la couche de stockage ayant le champ coercitif le moins élevé peut se retrouver elle aussi avec son aimantation inversée. Ainsi après avoir écrit la couche la plus dure magnétiquement, il est nécessaire d'écrire la couche ayant le plus faible champ coercitif.

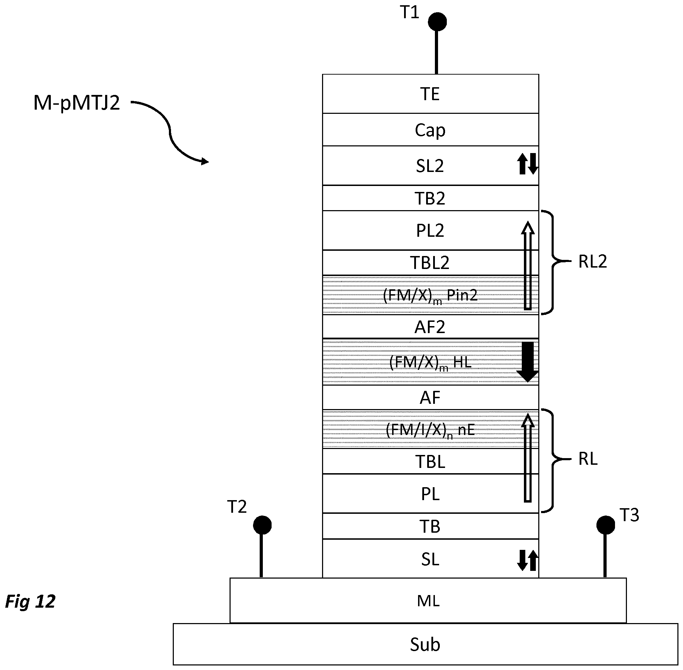

La figure 12 montre un point mémoire à trois terminaux pour une cellule mémoire à plusieurs niveaux M-pMTJ2 ayant deux couches de stockage SL et SL2.

La jonction magnétique tunnel à plusieurs niveaux M-pMTJ2 comprend les couches suivantes :

- une couche de substrat Sub ;
- Une ligne métallique ML comprenant un matériau ayant un angle Hall de spin élevé ;
- Un deuxième T2 et troisième T3 terminal connectés à la ligne métallique ML ;
- Une première couche de stockage SL ;
- Une première barrière tunnel TB ;
- Une première couche de transition structurale de symétrie TBL ;
- Une multicouche selon l'invention nE ayant le rôle de première couche de piégeage ;
- Une première couche de couplage antiferromagnétique AF ;
- Une couche dure HL ;
- Une deuxième couche de couplage antiferromagnétique AF2 ;
- Une deuxième couche de piégeage Pin2 ;
- Une deuxième couche de transition structurale de symétrie TBL2 ;
- Une deuxième couche de polarisation de spin PL2 ;
- Une deuxième couche de transition structurale de symétrie TBL2 ;
- Une couche protectrice Cap ;
- Une électrode supérieure TE ;
- Un premier terminal connecté à l'électrode supérieure TE.

La première couche de polarisation PL, la première couche de transition structurale de symétrie TBL et la multicouche selon l'invention nE constituent la première couche de référence RL.

Dans le point mémoire pour une cellule mémoire à plusieurs niveaux M-pMTJ2, chaque couche de stockage peut être écrite indépendamment de l'autre.

Quand une impulsion de courant circule le long de la ligne métallique ML entre les terminaux T2 et T3, un courant polarisé en spin généré par effet Hall de spin est injecté dans la première couche de stockage SL. Ce courant polarisé en spin exerce un couple spin-orbite sur l'aimantation de la couche de stockage qui peut être inversée si le couple est suffisant. Pour inverser l'aimantation dans la direction opposée, il faut inverser la direction de circulation de l'impulsion de courant le long de la ligne métallique ML.

L'écriture de la deuxième couche de stockage SL2 est effectuée par transfert de spin grâce à une impulsion de courant circulant perpendiculairement au plan des couches à travers l'empilement. Pour pouvoir effectuer les opérations

EP 3 528 256 B1

d'écriture des deux couches de stockage SL et SL2 de façon indépendante, la première couche de stockage SL possède un champ coercitif plus élevé que celui de la deuxième couche de stockage SL2. Cela permet de laisser inchangée l'aimantation de la première couche de stockage SL quand l'aimantation de la deuxième couche de stockage SL2 est inversée.

Si au contraire le champ coercitif de la première couche de stockage SL est plus faible que celui de la deuxième couche de stockage SL2, chaque inversion antiparallèle-parallèle de l'aimantation de la deuxième couche de stockage SL2 provoquera une inversion antiparallèle-parallèle de la première couche de stockage SL, si cette dernière était initialement dans l'état antiparallèle.

Pour remédier à ce problème il est nécessaire d'écrire à nouveau la première couche de stockage SL, comme il a été discuté aussi en référence à la figure 11.

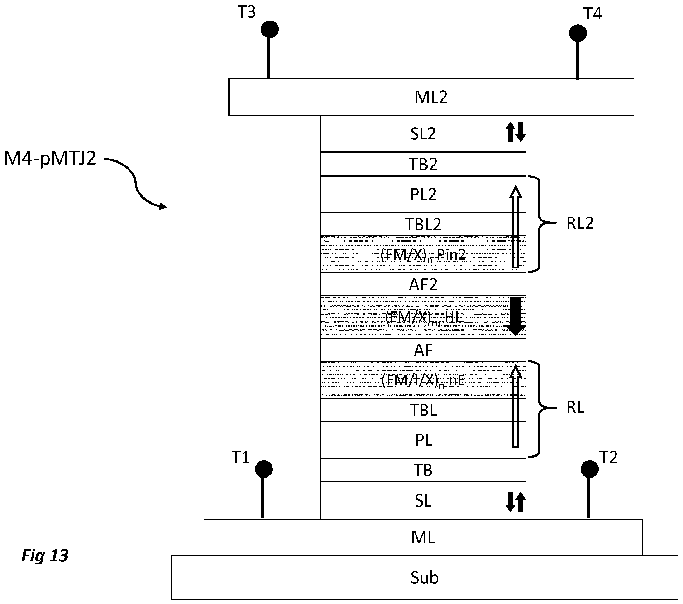

Le problème de la double écriture de la couche de stockage ayant le plus faible champ coercitif est résolu par un autre point mémoire selon l'invention et représenté à la figure 13.

La figure 13 représente un point mémoire à quatre terminaux pour une cellule mémoire à plusieurs niveaux M4-pMTJ.

Le point mémoire à quatre terminaux M4-pMTJ selon la figure 13 comprend :

- Une couche de substrat Sub ;
- Une première ligne métallique ML comprenant un matériau ayant un angle Hall de spin élevé ;
- Deux terminaux T3 et T4 connectés à la première ligne métallique ML ;
- Une première couche de stockage SL déposée au contact de la première ligne métallique ML ;
- Une première barrière tunnel TB ;
- Une première couche de polarisation PL ;
- Une première couche de transition structurale de symétrie TBL ;
- Une multicouche nE selon l'invention ayant le rôle de première couche de piégeage ;
- Une première couche de couplage antiferromagnétique AF ;
- Une couche dure HL ;
- Une deuxième couche de couplage antiferromagnétique AF2 ;
- Une deuxième couche de piégeage Pin2 ;
- Une deuxième couche de transition structurale de symétrie TBL2 ;
- Une deuxième couche de polarisation PL2 ;
- Une deuxième barrière tunnel TB2 ;
- Une deuxième couche de stockage SL2 ;
- Une deuxième ligne métallique ML2 comprenant un matériau ayant un angle de spin élevé, la deuxième ligne métallique étant déposée au contact de la deuxième couche de stockage SL2 ;
- Deux terminaux T1 et T2 placés au contact de la deuxième ligne métallique ML2.

La première couche de polarisation de spin PL, la première couche de transition structurale de symétrie TBL et la multicouche nE selon l'invention agissant en tant que première couche de piégeage constituent une première couche de référence RL.

La deuxième couche de piégeage Pin2, la deuxième couche de transition structurale de symétrie TBL2 et la deuxième couche de polarisation PL2 constituent une deuxième couche de référence RL2.

Dans la configuration illustrée à la figure 13, les deux couches de stockage SL et SL2 sont écrites par couple spin-orbite. L'inversion de l'aimantation de la première couche de stockage SL est faite grâce à une impulsion de courant circulant le long de la première ligne métallique ML entre les deux terminaux T3 et T4. De la même façon, l'écriture de la deuxième couche de stockage SL2 est réalisée grâce à une impulsion de courant circulant le long de la deuxième ligne métallique ML2 entre les deux terminaux T1 et T2.

Aucune erreur d'écriture n'est possible dans la configuration de la figure 13 et cela indépendamment des valeurs des champs coercitifs des deux couches de stockage SL et SL1.

Le point mémoire à quatre terminaux M4-pMTJ selon la figure 13 présente quatre états de résistance distincts. La lecture de la valeur de résistance est possible en utilisant un courant vertical, par exemple en choisissant un des terminaux de la première ligne métallique ML et un des terminaux de la deuxième ligne métallique ML2.

Alternativement, l'écriture des deux couches de stockage SL et SL2 peut être réalisée par nucléation de domaines magnétiques ou par propagation des parois de domaines magnétiques, comme il a été décrit en relation à la figure 9b. Dans ce cas, les deux lignes métalliques ML et ML2 sont constituées d'un matériau antiferromagnétique ayant un angle Hall de spin élevé. Des exemples d'un tel matériau sont IrMn ou PtMn. Ces méthodes d'écriture sont applicables non seulement pour des points mémoires à plusieurs niveaux de type SOT-MRAM mais également pour des dispositifs de type memristor.

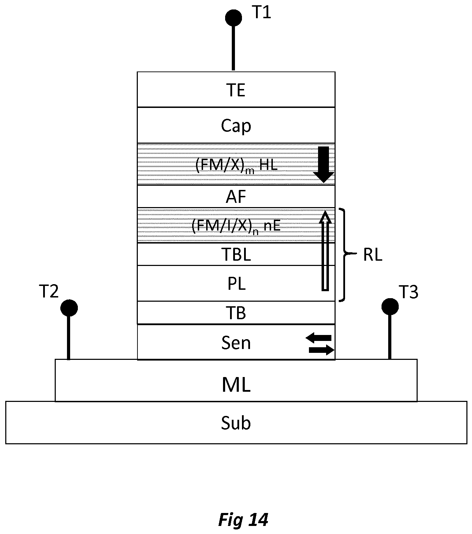

La figure 14 illustre un capteur de température et de champ magnétique comprenant une multicouche nE selon l'invention.

Le capteur illustré à la figure 14 comprend :

- Une couche de substrat Sub;
- Une ligne métallique ML, typiquement en Pt ;
- Une couche de détection Sen placée au-dessus et au contact de la ligne métallique ML ;
- Une barrière tunnel TB ;
- Une couche de polarisation de spin PL ;
- Une couche de transition structurale de symétrie TBL ;
- Une multicouche nE selon l'invention ayant le rôle de couche de piégeage ;
- Une couche de couplage antiferromagnétique AF ;
- Une couche dure HL ;
- Une couche de protection Cap ;
- Une électrode supérieure TE.

Un premier terminal électrique T1 est connecté à l'électrode supérieure. Un deuxième T2 et un troisième T3 terminal sont connectés à la ligne métallique ML.

La couche de polarisation PL, la couche de transition structurale de symétrie TBL et le multicouche nE selon l'invention forment une couche de référence RL.

Selon une variante, la couche dure HL peut également comprendre une multicouche nE selon l'invention du type $(FM/X/I)_n$.

La couche de détection possède une aimantation dans le plan en absence de champ magnétique extérieur appliqué. Le champ magnétique à mesurer est orienté selon la direction normale aux couches. Sous l'action du champ magnétique à mesurer, l'aimantation de la couche de détection est tirée hors du plan et s'oriente parallèlement ou antiparallèlement à l'aimantation de la couche de référence suivant la direction du champ magnétique à mesurer. Il est donc possible de mesurer une résistance qui dépend du champ magnétique à mesurer du fait de la magnétorésistance tunnel de l'empilement.

Pour lire la valeur de la résistance, il est possible de mesurer la tension électrique entre le premier terminal T1 et l'un des terminaux T2 ou T3 de la ligne métallique ML en faisant circuler un courant d'intensité déterminée à travers l'empilement entre les terminaux T1 et T2 ou T3.

La couche de détection peut être une couche simple ou un empilement de couches formant une couche antiferromagnétique synthétique. Avantageusement, dans le deuxième cas il est possible de réduire le champ parasite d'origine magnétostatique entre la couche de détection et les couches de piégeage.

La susceptibilité magnétique perpendiculaire de la couche de détection peut être modifiée en faisant varier l'épaisseur de la couche de détection, ce qui permet de modifier la sensibilité du capteur de champ magnétique.

De façon générale, la résistance des couches, la magnétorésistance et la sensibilité du capteur selon la figure 14 dépendent de la température. Il est donc nécessaire de mesurer la température du capteur pour pouvoir remonter à la valeur du champ magnétique en partant d'une valeur mesurée de magnétorésistance. La température peut être mesurée en mesurant la résistance de la ligne métallique ML entre les terminaux T2 et T3. Cette mesure de la résistance de la ligne ML doit être effectuée à courant suffisamment faible de sorte que l'influence d'un éventuel couple de spin orbite induit par la circulation du courant dans la ligne ML sur l'aimantation de la couche Sen ne vienne perturber la lecture du signal de magnétorésistance entre les terminaux T1 et T2 ou T3. En pratique, il peut être préférable d'effectuer les deux mesures de résistance électrique entre les terminaux T1 et T2 ou T3 (mesure du champ magnétique) et entre les terminaux T2 et T3 (mesure de la température) à deux intervalles de temps séparés et consécutifs.

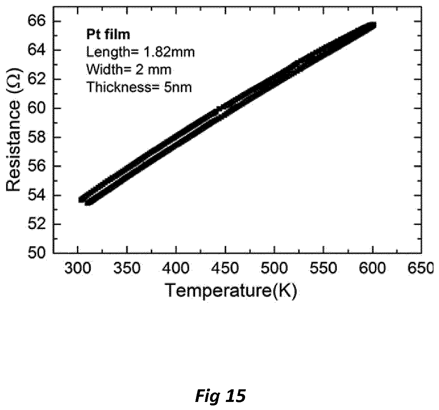

En choisissant un métal tel que le Pt, la résistance mesurée dépend quasi-linéairement de la température, comme il est illustré à la figure 15.

Le dispositif selon la figure 14 peut donc être utilisé pour mesurer la température et un champ magnétique extérieur perpendiculaire au plan des couches.

## Revendications

1. Multicouche (nE) comprenant au moins un premier et un deuxième empilement magnétique, la multicouche présentant une aimantation hors du plan, chacun desdits premier et deuxième empilement magnétique comprenant :

   - Un premier élément (E1) comprenant une couche ferromagnétique ;
   - Un deuxième élément (X) constitué d'une couche métallique apte à conférer à un ensemble formé par le premier et le deuxième éléments une anisotropie magnétique perpendiculaire au plan des couches,

le premier élément (E1) comprenant en outre un matériau métallique réfractaire, le deuxième élément (X) étant disposé directement sur le premier élément, le premier élément du deuxième empilement magnétique étant disposé sur le deuxième élément du premier empilement magnétique.

2.  Multicouche (nE) selon la revendication précédente **caractérisé en ce que** :

    - La couche ferromagnétique du premier élément (E1) comprend un ou plusieurs matériaux pris dans un premier groupe de matériaux, ledit premier groupe de matériaux étant constitué par les matériaux suivants : cobalt, fer, nickel et les alliages magnétiques à base de ces matériaux ; et/ou
    - La couche métallique du deuxième élément (X) comprend un ou plusieurs matériaux pris dans un deuxième groupe de matériaux, ledit deuxième groupe de matériaux étant constitué par les matériaux suivants : platine, or, iridium, palladium, nickel, NiCo, NiFe, NiFeCo et les alliages à base de ces matériaux.

3.  Multicouche (nE) selon la revendication précédente **caractérisé en ce que** la couche ferromagnétique du premier élément (E1) comprend un alliage à base d'un ou plusieurs matériaux pris dans le premier groupe de matériaux et du matériau métallique réfractaire.

4.  Multicouche (nE) selon la revendication 1 et la revendication 2 **caractérisé en ce que** le premier élément (E1) comprend une première couche (FM) du premier élément et une deuxième couche (1) du premier élément, la première couche (FM) du premier élément (E1) comprenant un ou plusieurs matériaux pris dans le premier groupe de matériaux et la deuxième couche du premier élément (I) magnétique (E1) étant constituée du matériau métallique réfractaire.

5.  Multicouche (nE) selon l'une des revendications précédentes **caractérisé en ce que** le matériau métallique réfractaire est pris dans le groupe suivant : tantale, tungstène, molybdène, ruthénium, zirconium, vanadium, niobium.

6.  Multicouche (nE) selon l'une des revendications précédentes **caractérisé en ce que** le matériau métallique réfractaire possède une température de fusion supérieure à 1600 °C, ladite température de fusion étant mesurée à la pression de 1 bar.

7.  Multicouche (nE) selon l'une des revendications 4 à 6 précédentes **caractérisé en ce que** la deuxième couche du premier élément (I) magnétique possède une épaisseur comprise entre 0.1 et 0.6 nm et de préférence entre 0.2 et 0.4 nm.

8.  Jonction tunnel magnétique (MTJ1) comprenant :

    - Une première multicouche magnétique dite couche de référence (RL) ;
    - Une deuxième multicouche magnétique dite couche de stockage (SL) ;
    - Une couche barrière tunnel (TB) qui sépare la couche de référence (RL) et la couche de stockage (SL) ;

    ladite jonction tunnel magnétique étant **caractérisée en ce que** la couche de référence (RL) comprend une multicouche (nE) selon l'une des revendications 1 à 7.

9.  Jonction tunnel magnétique (MTJ1) selon la revendication précédente **caractérisé en ce que** la couche barrière tunnel (TB) est placée au-dessus de la couche de stockage (SL).

10. Point mémoire (PM) à deux ou trois terminaux comprenant :

    - Une électrode supérieure (TE) au contact d'un premier terminal (T1) ;
    - Une multicouche magnétique dite couche de référence (RL) comprenant au moins une multicouche (nE) selon l'une des revendications 1 à 7 ;
    - Une multicouche magnétique dite couche de stockage (SL) ;
    - Une couche barrière tunnel (TB) séparant la couche de référence et la couche de stockage ;
    - Un deuxième terminal en contact électrique avec la couche de stockage (SL) ou une ligne métallique (ML) reliée électriquement à un deuxième (T2) et troisième terminaux (T3), placée au-dessous de la couche de stockage (SL) et au contact électrique de la couche de stockage (SL).

11. Point mémoire selon la revendication précédente **caractérisé en ce que** la ligne métallique conductrice est une ligne métallique conductrice antiferromagnétique (AF-ML).

**12.** Point mémoire à trois terminaux comprenant :

- Une électrode supérieure (TE) connectée à un premier terminal (T1) ;
- Une première multicouche magnétique dite couche de référence (RL) comprenant au moins une multicouche (nE) selon l'une des revendications 1 à 7 ;
- Une multicouche magnétique dite couche de stockage (SL), un deuxième (T2) et un troisième (T3) terminaux étant connectés à ladite couche de stockage (SL) ;
- Une couche barrière tunnel (TB) séparant la couche de référence et la couche de stockage.

**13.** Point mémoire selon l'une quelconque des revendications 10 à 12 **caractérisé en ce que** le point mémoire est à trois terminaux et la couche de stockage (SL) a une géométrie de type « racetrack ».

**14.** Double jonction tunnel magnétique (DMTJ) comprenant :

- Une première multicouche magnétique dite première couche de référence (RL) ;
- Une deuxième multicouche magnétique dite couche de stockage (SL) ;
- Une troisième multicouche magnétique dite deuxième couche de référence (RL2) comprenant une multicouche (nE) selon l'une des revendications 1 à 7 ;
- Une première couche barrière tunnel (TB) séparant la première couche de référence (RL) et la couche de stockage (SL) ;
- Une deuxième couche barrière tunnel (TB2) séparant la deuxième couche de référence (RL2) et la couche de stockage (SL).

**15.** Jonction tunnel magnétique pour une cellule mémoire à plusieurs niveaux (M-pMTJ) comprenant :

- Une première multicouche magnétique dite première couche de stockage (SL) ;
- Une deuxième multicouche magnétique dite première couche de référence (RL) comprenant une multicouche (nE) selon l'une des revendications 1 à 7 ;
- Une première couche barrière tunnel (TB) séparant la première couche de référence (RL) et la première couche de stockage ;
- Une troisième multicouche magnétique dite deuxième couche de référence (RL2) ;
- Une quatrième multicouche magnétique dite deuxième couche de stockage (SL2) ;
- Une deuxième couche barrière tunnel (TB) séparant la deuxième couche de référence (RL2) et la deuxième couche de stockage (SL2).

**16.** Point mémoire à trois terminaux pour une cellule mémoire à plusieurs niveaux (M-pMTJ2) comprenant :

- Une ligne métallique (ML) connectée à un deuxième (T2) et un troisième (T3) terminal ;
- Une première multicouche magnétique dite première couche de stockage (SL) placée au-dessus de la ligne métallique (ML) et au contact de ladite ligne métallique (ML) ;
- Une deuxième multicouche magnétique dite première couche de référence (RL) comprenant une multicouche (nE) selon l'une des revendications 1 à 7 ;
- Une troisième multicouche magnétique dite deuxième couche de référence (RL2) ;
- Une quatrième multicouche magnétique dite deuxième couche de stockage (SL2).
- Une électrode supérieure (TE) connectée à un premier terminal (T1).

**17.** Point mémoire à quatre terminaux pour une cellule mémoire à plusieurs niveaux (M4-pMTJ2) comprenant :

- Une première ligne métallique (ML) connectée à un premier (T1) et à un deuxième (T2) terminal ;
- Une première multicouche magnétique dite première couche de stockage (SL) placée au-dessus de la première ligne métallique (ML) et au contact de ladite première ligne métallique (ML) ;
- Une deuxième multicouche magnétique dite première couche de référence (RL) comprenant une multicouche (nE) selon l'une des revendications 1 à 7 ;
- Une première couche barrière tunnel (TB) séparant la première couche de stockage (SL) et la première couche de référence (RL) ;
- Une troisième multicouche magnétique dite deuxième couche de référence (RL2) ;

- Une quatrième multicouche magnétique dite deuxième couche de stockage (SL2) ;
- Une deuxième ligne métallique (ML2) connectée à un troisième (T3) et à un quatrième (T4) terminal, ladite deuxième ligne métallique (ML2) étant placée au-dessus de la deuxième couche de stockage (SL2) et au contact de ladite deuxième couche de stockage (ML2) ;
- Une deuxième couche barrière tunnel (TB2) séparant la deuxième couche de stockage (SL2) et la deuxième couche de référence (RL2).

18. Capteur pour la mesure d'un champ magnétique appliqué comprenant :

- Une électrode supérieure (TE) connectée à un premier terminal (T1) ;
- Une première multicouche magnétique dite couche de référence (RL) comprenant une multicouche (nE) selon l'une des revendications 1 à 7 ;
- Une deuxième multicouche magnétique dite couche de détection (Sen) ayant une aimantation orientée parallèlement au plan des couches en absence de champ magnétique appliqué ;
- Une couche barrière tunnel (TB) séparant la couche détection (Sen) et la couche de référence (RL) ;
- Au moins un deuxième terminal relié électriquement à la couche de détection.

19. Capteur pour la mesure d'un champ magnétique appliqué selon la revendication précédente **caractérisé en ce qu'**il est configuré pour mesurer la température et **en ce qu'**il comprend une ligne métallique connectée à un deuxième (T2) et à un troisième (T3) terminal, ladite ligne métallique étant au-dessous de la couche de détection (Sen) et au contact électrique de ladite couche de détection (Sen).

**Patentansprüche**

1. Mehrfachschicht (nE), die mindestens einen ersten und einen zweiten magnetischen Stapel umfasst, wobei die Mehrfachschicht eine Magnetisierung über die Ebene hinaus aufweist und jeder des ersten und zweiten magnetischen Stapels umfasst:

   - Ein erstes Element (E1), das eine ferromagnetische Schicht umfasst;
   - Ein zweites Element (X), das aus einer Metallschicht besteht, die geeignet ist, einer aus dem ersten und dem zweiten Element gebildeten Anordnung eine magnetische Anisotropie senkrecht zur Ebene der Schichten zu verleihen,

   wobei das erste Element (E1) ferner ein feuerfestes metallisches Material umfasst und das zweite Element (X) direkt auf dem ersten Element angeordnet ist, wobei das erste Element des zweiten magnetischen Stapels auf dem zweiten Element des ersten magnetischen Stapels angeordnet ist.

2. Mehrfachschicht (nE) nach vorausgehendem Anspruch, **dadurch gekennzeichnet, dass**:

   - Die ferromagnetische Schicht des ersten Elements (E1) ein oder mehrere Materialien aus einer ersten Gruppe von Materialien umfasst, wobei die erste Gruppe von Materialien aus den folgenden Materialien besteht: Kobalt, Eisen, Nickel und magnetische Legierungen auf der Basis dieser Materialien; und/oder
   - Die Metallschicht des zweiten Elements (X) ein oder mehrere Materialien aus einer zweiten Gruppe von Materialien umfasst, wobei die zweite Gruppe von Materialien aus den folgenden Materialien besteht: Platin, Gold, Iridium, Palladium, Nickel, NiCo, NiFe, NiFeCo und Legierungen auf der Basis dieser Materialien.

3. Mehrfachschicht (nE) nach vorhergehendem Anspruch, **dadurch gekennzeichnet, dass** die ferromagnetische Schicht des ersten Elements (E1) eine Legierung auf der Basis eines oder mehrerer Materialien aus der ersten Gruppe von Materialien und des feuerfesten metallischen Materials umfasst.

4. Mehrfachschicht (nE) nach Anspruch 1 und Anspruch 2, **dadurch gekennzeichnet, dass** das erste Element (E1) eine erste Schicht (FM) des ersten Elements und eine zweite Schicht (1) des ersten Elements umfasst, wobei die erste Schicht (FM) des ersten Elements (E1) ein oder mehrere Materialien aus der ersten Gruppe von Materialien umfasst und die zweite Schicht des ersten magnetischen Elements (1) (E1) aus dem feuerfesten metallischen Material besteht.

5. Mehrfachschicht (nE) nach einem der vorhergehenden Ansprüche, **dadurch gekennzeichnet, dass** das feuerfeste metallische Material aus der folgenden Gruppe ausgewählt ist: Tantal, Wolfram, Molybdän, Ruthenium, Zirkonium, Vanadium, Niobium.

6. Mehrfachschicht (nE) nach einem der vorhergehenden Ansprüche, **dadurch gekennzeichnet, dass** das feuerfeste metallische Material eine Schmelztemperatur von über 1600 °C besitzt, wobei die Schmelztemperatur bei einem Druck von 1 bar gemessen wird.

7. Mehrfachschicht (nE) nach einem der vorhergehenden Ansprüche 4 bis 6, **dadurch gekennzeichnet, dass** die zweite Schicht des ersten magnetischen Elements (1) eine Dicke zwischen 0,1 und 0,6 nm und vorzugsweise zwischen 0,2 und 0,4 nm besitzt.

8. Magnetischer Tunnelübergang (MTJ 1), umfassend:

   - Eine erste magnetische Mehrfachschicht, die als Referenzschicht (RL) bezeichnet wird;
   - Eine zweite magnetische Mehrfachschicht, die als Speicherschicht (SL) bezeichnet wird;
   - Eine Tunnelsperrschicht (TB), die die Speicherschicht (SL) und die Referenzschicht (RL) trennt;

   wobei der magnetische Tunnelübergang **dadurch gekennzeichnet ist, dass** die Referenzschicht (RL) eine Mehrfachschicht (nE) nach einem der Ansprüche 1 bis 7 umfasst.

9. Magnetischer Tunnelübergang (MTJ 1) nach dem vorhergehenden Anspruch, **dadurch gekennzeichnet, dass** die Tunnelsperrschicht (TB) über der Speicherschicht (SL) angeordnet ist.

10. Speicherpunkt (PM) mit zwei oder drei Anschlüssen, umfassend:

   - Eine obere Elektrode (TE), die mit einem ersten Anschluss (T1) in Kontakt ist;
   - Eine magnetische Mehrfachschicht, Referenzschicht (RL) genannt, mit mindestens einer Mehrfachschicht (nE) nach einem der Ansprüche 1 à 7;
   - Eine magnetische Mehrfachschicht, die als Speicherschicht (SL) bezeichnet wird;
   - Eine Tunnelsperrschicht (TB), die die Speicherschicht und die Referenzschicht trennt;
   - Einen zweiten Anschluss, der in elektrischem Kontakt mit der Speicherschicht (SL) oder einer Metallleitung (ML) steht, die mit einem zweiten (T2) und dritten (T3) Anschluss elektrisch verbunden ist und die unterhalb der Speicherschicht (SL) angeordnet ist und in elektrischem Kontakt mit der Speicherschicht (SL) steht.

11. Speicherpunkt nach dem vorhergehenden Anspruch, **dadurch gekennzeichnet, dass** die leitfähige Metallleitung eine antiferromagnetische leitfähige Metallleitung (AF-ML) ist.

12. Speicherpunkt mit drei Anschlüssen, umfassend:

   - Eine obere Elektrode (TE), die mit einem ersten Anschluss (T1) verbunden ist;
   - Eine erste magnetische Mehrfachschicht, die sogenannte Referenzschicht (RL), mit mindestens einer Mehrfachschicht (nE) nach einem der Ansprüche 1 bis 7;
   - Eine magnetische Mehrfachschicht, die als Speicherschicht (SL) bezeichnet wird, wobei ein zweiter (T2) und ein dritter (T3) Anschluss mit der Speicherschicht (SL) verbunden sind;
   - Eine Tunnelsperrschicht (TB), die die Speicherschicht und die Referenzschicht trennt;

13. Speicherpunkt nach einem der Ansprüche 10 bis 12 **dadurch gekennzeichnet, dass** der Speicherpunkt drei Anschlüsse und die Speicherschicht (SL) eine Racetrack-Geometrie aufweist.

14. Magnetischer Doppeltunnelübergang (DMTJ), umfassend:

   - Eine erste magnetische Mehrfachschicht, die als erste Referenzschicht (RL) bezeichnet wird;
   - Eine zweite magnetische Mehrfachschicht, die als Speicherschicht (SL) bezeichnet wird;
   - Eine dritte magnetische Mehrfachschicht, die sogenannte zweite Referenzschicht (RL2), die eine Mehrfachschicht (nE) nach einem der Ansprüche 1 bis 7 umfasst;
   - Eine erste Tunnelsperrschicht (TB), die die Speicherschicht (SL) und die erste Referenzschicht (RL) trennt;
   - Eine zweite Tunnelsperrschicht (TB2), die die zweite Referenzschicht (RL2) und die Speicherschicht (SL) voneinander trennt.

**15.** Magnetischer Tunnelübergang für eine Multilevel-Speicherzelle (M pMTJ), umfassend:

- Eine erste magnetische Mehrfachschicht, die als erste Speicherschicht (SL) bezeichnet wird;
- Eine zweite magnetische Mehrfachschicht, die als erste Referenzschicht (RL) bezeichnet wird, die eine Mehrfachschicht (nE) nach einem der Ansprüche 1 bis 7 umfasst;
- Eine erste Tunnelsperrschicht (TB), die die erste Referenzschicht (RL) und die erste Speicherschicht trennt;
- Eine dritte magnetische Mehrfachschicht, die als zweite Referenzschicht (RL2) bezeichnet wird;
- Eine vierte magnetische Mehrfachschicht, die als zweite Speicherschicht (SL2) bezeichnet wird;
- Eine zweite Tunnelsperrschicht (TB), die die zweite Referenzschicht (RL2) und die zweite Speicherschicht (SL2) voneinander trennt.

**16.** Speicherpunkt mit drei Anschlüssen für eine Multilevel-Speicherzelle (M-pMTJ2), umfassend:

- Eine Metallleitung (ML), die mit einem zweiten (T2) und einem dritten (T3) Anschluss verbunden ist;
- Eine erste magnetische Mehrfachschicht, die sogenannte erste Speicherschicht (SL), die über der Metallleitung (ML) und in Kontakt mit der Metallleitung (ML) angeordnet ist;
- Eine zweite magnetische Mehrfachschicht, die als erste Referenzschicht (RL) bezeichnet wird und eine Mehrfachschicht (nE) nach einem der Ansprüche 1 bis 7 umfasst;
- Eine dritte magnetische Mehrfachschicht, die als zweite Referenzschicht (RL2) bezeichnet wird;
- Eine vierte magnetische Mehrfachschicht, die als zweite Speicherschicht (SL2) bezeichnet wird.
- Eine obere Elektrode (TE), die mit einem ersten Anschluss (T1) verbunden ist.

**17.** Speicherpunkt mit vier Anschlüssen für eine Multilevel-Speicherzelle (M4-pMTJ2), umfassend:

- Eine erste Metallleitung (ML), die mit einem ersten (T1) und einem zweiten (T2) Anschluss verbunden ist;
- Eine erste magnetische Mehrfachschicht, die sogenannte erste Speicherschicht (SL), die über der ersten Metallleitung (ML) und in Kontakt mit der ersten Metallleitung (ML) angeordnet ist;
- Eine zweite magnetische Mehrfachschicht, die sogenannte erste Referenzschicht (RL), die eine Mehrfachschicht (nE) nach einem der Ansprüche 1 bis 7 umfasst;
- Eine erste Tunnelsperrschicht (TB), die die erste Speicherschicht (SL) und die erste Referenzschicht (RL) trennt;
- Eine dritte magnetische Mehrfachschicht, die als zweite Referenzschicht (RL2) bezeichnet wird;
- Eine vierte magnetische Mehrfachschicht, die als zweite Speicherschicht (SL2) bezeichnet wird;
- Eine zweite Metallleitung (ML2), die mit einem dritten (T3) und einem vierten (T4) Anschluss verbunden ist, wobei die zweite Metallleitung (ML2) über der zweiten Speicherschicht (SL2) und in Kontakt mit der zweiten Speicherschicht (ML2) angeordnet ist;
- Eine zweite Tunnelsperrschicht (TB), die die zweite Referenzschicht (RL2) und die zweite Speicherschicht (SL2) voneinander trennt.

**18.** Sensor zur Messung eines angelegten Magnetfeldes, umfassend:

- Eine obere Elektrode (TE), die mit einem ersten Anschluss (T1) verbunden ist;
- Eine erste magnetische Mehrfachschicht, die sogenannte Referenzschicht (RL), die eine Mehrfachschicht (nE) nach einem der Ansprüche 1 bis 7 umfasst;
- Eine zweite magnetische Mehrfachschicht, die sogenannte Sensorschicht (Sen), mit einer Magnetisierung, die in Abwesenheit eines angelegten Magnetfelds parallel zur Ebene der Schichten ausgerichtet ist;
- Eine Tunnelsperrschicht **(TB)**, die die Sensorschicht (Sen) und die Referenzschicht **(RL)** trennt;
- Mindestens einen zweiten Anschluss, der elektrisch mit der Sensorschicht verbunden ist.

**19.** Sensor zur Messung eines angelegten Magnetfelds nach dem vorhergehenden Anspruch, **dadurch gekennzeichnet, dass** er zur Temperaturmessung konfiguriert ist und dass er eine Metallleitung umfasst, die mit einem zweiten (T2) und einem dritten (T3) Anschluss verbunden ist, wobei sich die Metallleitung unterhalb der Sensorschicht (Sen) und in elektrischem Kontakt mit der Sensorschicht (Sen) befindet.

**Claims**

**1.** Multilayer (nE) including at least a first and a second magnetic stack, the multilayer having an out-of-plane magnetisation, each of said first and second magnetic stacks including:

- A first element (E1) including a ferromagnetic layer;
- A second element (X) constituted of a metal layer able to confer on the assembly formed by the first and the second elements a magnetic anisotropy perpendicular to the plane of the layers,

the first element (E1) further includes a refractory metal material, the second element (X) being arranged on the first element, the first element of the second magnetic stack being arranged on the second element of the first magnetic stack.

2. Multilayer (nE) according to the preceding claim **characterised in that**:

- The ferromagnetic layer of the first element (E1) includes one or more materials taken from a first group of materials, said first group of materials being constituted of the following materials: cobalt, iron, nickel and magnetic alloys based on these materials; and/or
- The metal layer of the second element (X) includes one or more materials taken from a second group of materials, said second group of materials being constituted of the following materials: platinum, gold, iridium, palladium, nickel, NiCo, NiFe, NiFeCo and alloys based on these materials.

3. Multilayer (nE) according to the preceding claim **characterised in that** the ferromagnetic layer of the first element (E1) includes an alloy based on one or more materials taken from the first group of materials and on the refractory metal material.

4. Multilayer (nE) according to claim 1 and claim 2 **characterised in that** the first element (E1) includes a first layer (FM) of the first element and a second layer (I) of the first element, the first layer (FM) of the first element (E1) including one or more materials taken from the first group of materials and the second layer of the first magnetic (E1) element (I) being constituted of the refractory metal material.

5. Multilayer (nE) according to one of the preceding claims **characterised in that** the refractory metal material is taken from the following group: tantalum, tungsten, molybdenum, ruthenium, zirconium, vanadium, niobium.

6. Multilayer (nE) according to one of the preceding claims **characterised in that** the refractory metal material has a melting temperature above 1600°C, said melting temperature being measured at the pressure of 1 bar.

7. Multilayer (nE) according to one of the preceding claims 4 to 6 **characterised in that** the second layer of the first magnetic element (I) has a thickness comprised between 0.1 and 0.6 nm and preferably between 0.2 and 0.4 nm.

8. Magnetic tunnel junction (MTJ1) including:

- A first magnetic multilayer designated reference layer (RL);
- A second magnetic multilayer designated storage layer (SL);
- A tunnel barrier layer (TB) which separates the reference layer (RL) and the storage layer (SL);

said magnetic tunnel junction being **characterised in that** the reference layer (RL) includes a multilayer (nE) according to one of claims 1 to 7.

9. Magnetic tunnel junction (MTJ1) according to the preceding claim **characterised in that** the tunnel barrier layer (TB) is placed above the storage layer (SL).

10. Memory point (PM) with two or three terminals including:

- A top electrode (TE) in contact with a first terminal (T1);
- A magnetic multilayer designated reference layer (RL) including at least one multilayer (nE) according to one of claims 1 to 7;
- A magnetic multilayer designated storage layer (SL);
- A tunnel barrier layer (TB) separating the reference layer and the storage layer;
- A second terminal in electrical contact with the storage layer (SL) or a metal line (ML) electrically connected to second (T2) and third (T3) terminals, placed below the storage layer (SL) and in electrical contact with the storage

EP 3 528 256 B1

layer (SL).

11. Memory point according to the preceding claim **characterised in that** the conductive metal line is a conductive antiferromagnetic metal line (AF-ML).

12. Memory point with three terminals including:

- A top electrode (TE) connected to a first terminal (T1);
- A first magnetic multilayer designated reference layer (RL) including at least one multilayer (nE) according to one of claims 1 to 7;
- A magnetic multilayer designated storage layer (SL), a second (T2) and a third (T3) terminal being connected to said storage layer (SL);
- A tunnel barrier layer (TB) separating the reference layer and the storage layer.

13. Memory point according to any of claims 10 to 12 **characterised in that** the storage layer (SL) has a "racetrack" type geometry.

14. Double magnetic tunnel junction (DMTJ) including:

- A first magnetic multilayer designated first reference layer (RL);
- A second magnetic multilayer designated storage layer (SL);
- A third magnetic multilayer designated second reference layer (RL2) including a multilayer (nE) according to one of claims 1 to 7;
- A first tunnel barrier layer (TB) separating the first reference layer (RL) and the storage layer (SL);
- A second tunnel barrier layer (TB2) separating the second reference layer (RL2) and the storage layer (SL).

15. Magnetic tunnel junction for a memory cell with several levels (M-pMTJ) including:

- A first magnetic multilayer designated first storage layer (SL);
- A second magnetic multilayer designated first reference layer (RL) including a multilayer (nE) according to one of claims 1 to 7;
- A first tunnel barrier layer (TB) separating the first reference layer (RL) and the first storage layer;
- A third magnetic multilayer designated second reference layer (RL2);
- A fourth magnetic multilayer designated second storage layer (SL2);
- A second tunnel barrier layer (TB) separating the second reference layer (RL2) and the second storage layer (SL2).

16. Memory point with three terminals for a memory cell with several levels (M-pMTJ2) including:

- A metal line (ML) connected to a second (T2) and a third (T3) terminal;
- A first magnetic multilayer designated first storage layer (SL) placed above the metal line (ML) and in contact with said metal line (ML);
- A second magnetic multilayer designated first reference layer (RL) including a multilayer (nE) according to one of claims 1 to 7;
- A third magnetic multilayer designated second reference layer (RL2);
- A fourth magnetic multilayer designated second storage layer (SL2).
- A top electrode (TE) connected to a first terminal (T1).

17. Memory point with four terminals for a memory cell with several levels (M4-pMTJ2) including:

- A first metal line (ML) connected to a first (T1) and to a second (T2) terminal;
- A first magnetic multilayer designated first storage layer (SL) placed above the first metal line (ML) and in contact with said first metal line (ML);
- A second magnetic multilayer designated first reference layer (RL) including a multilayer (nE) according to one of claims 1 to 7;
- A first tunnel barrier layer (TB) separating the first storage layer (SL) and the first reference layer (RL);
- A third magnetic multilayer designated second reference layer (RL2);
- A fourth magnetic multilayer designated second storage layer (SL2);

- A second metal line (ML2) connected to a third (T3) and to a fourth (T4) terminal, said second metal line (ML2) being placed above the second storage layer (SL2) and in contact with said second storage layer (ML2);
- A second tunnel barrier layer (TB2) separating the second storage layer (SL2) and the second reference layer (RL2).

18. Sensor for the measurement of an applied magnetic field including:

- A top electrode (TE) connected to a first terminal (T1);
- A first magnetic multilayer designated reference layer (RL) including a multilayer (nE) according to one of claims 1 to 7;
- A second magnetic multilayer designated detection layer (Sen) having a magnetisation oriented parallel to the plane of the layers in the absence of applied magnetic field;
- A tunnel barrier layer (TB) separating the detection layer (Sen) and the reference layer (RL);
- At least one second terminal electrically connected to the detection layer.

19. Sensor for the measurement of an applied magnetic field according to the preceding claim **characterised in that** it is configured to measure the temperature and **in that** it includes a metal line connected to a second (T2) and to a third (T3) terminal, said metal line being below the detection layer (Sen) and in electrical contact with said detection layer (Sen).

**Fig 1a**

**Fig 1b**

E { X
E1 {

| |
|---|
| I |
| FM |

*Fig 2a*

nE {
X

| |
|---|
| Cap |
| X |
| I |
| FM |
| A |
| Sub |

E1

*Fig 2b*

MTJ1     MTJ1

**Fig 3a**

| Cap |
|---|
| X |
| I |
| FM |
| TBL |
| PL |
| TB |
| SL |
| S |
| BE |
| Sub |

RL   nE

**Fig 3b**

| TE |
|---|
| Cap |
| [FM/I/X]$_m$ HL |
| AF |
| [FM/I/X]$_n$ nE |
| TBL |
| PL |
| TB |
| SL |
| S |
| BE |
| Sub |

RL   pSAF

*Fig 4*

Fig 5a                              Fig 5b

*Fig 6*

*Fig 7*

*Fig 8*

**Fig 9a**

*Fig 9b*

*Fig 9c*

T1

| TE |
| Cap |
| (FM/X)$_m$ HL |
| AF |
| (FM/I/X)$_n$ nE |
| TBL |
| PL |
| TB |

RL

T2

T3

SL

Sub

**Fig 9d**

DMTJ

| TE |
| Cap |
| (FM/X)$_m$ HL2 |
| AF2 |
| (FM/I/X)$_n$ nE |
| TBL2 |
| PL2 |
| TB2 |
| SL |
| TB |
| PL |
| TBL |
| (FM/X)$_n$ Pin |
| AF |
| (FM/X)$_m$ HL |
| S |
| BE |
| Sub |

RL2

RL

pSAF2

pSAF

Fig 10

M-pMTJ

| TE |
| Cap |
| SL2 |
| TB2 |
| PL2 |
| TBL2 |
| $(FM/X)_n$ Pin2 |
| AF2 |
| $(FM/X)_m$ HL |
| AF |
| $(FM/I/X)_n$ nE |
| TBL |
| PL |
| TB |
| SL |
| S |
| BE |
| Sub |

RL2

RL

*Fig 11*

M-pMTJ2

Fig 12

T3    T4

ML2

SL2    ⬆⬇

M4-pMTJ2

TB2

PL2    ⬆

TBL2

(FM/X)$_n$ Pin2    } RL2

AF2

(FM/X)$_m$ HL    ⬇

AF

(FM/I/X)$_n$ nE    ⬆

TBL    } RL

PL

T1    TB    T2

SL    ⬇⬆

ML

**Fig 13**

Sub

T1

| TE |
|---|
| Cap |
| (FM/X)$_m$ HL |
| AF |
| (FM/I/X)$_n$ nE |
| TBL |
| PL |
| TB |
| Sen |

RL

T2

T3

| ML |
|---|

| Sub |
|---|

**Fig 14**

*Fig 15*

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2976396

- WO 2017052606 A1

**Littérature non-brevet citée dans la description**

- **J. SWERTS et al.** Top pinned magnetic tunnel junction stacks with high annealing tolerance for high density STT-MRAM applicants. *2017 IEEE International Magnetics Conference*, 24 April 2017, 1
- **JYOTIRMOY CHATTERJEE et al.** Enhanced annealing stability and perpendicular magnetic anisotropy in perpendicular magnetic tunnel junctions using W layer. *Applied Physics Letters*, 15 May 2017, vol. 110 (20), 1-5

- **S. FUKAMI et al.** Magnetization switching by spin-orbit torque in an antiferromagnet-ferromagnet bilayer system. *Nature Materials*, 2016, vol. 15, 535-541
- **S.S. PARKIN et al.** Magnetic domain-wall racetrack memory. *Science*, 2008, vol. 320 (5873), 190-194